# EUROPEAN PATENT APPLICATION

(11) **EP 4 431 976 A1**
(43) Date of publication of application: **18.09.2024**
(21) Application number: 24162632.4
(22) Date of filing: 11.03.2024
(51) Int. Cl.: G01S 7/481, G01S 7/4865

(54) **LIDAR, AUTONOMOUS DRIVING SYSTEM, AND MOVABLE DEVICE**

(30) Priority: 15.03.2023 CN 202310270884
(71) Applicant: Suteng Innovation Technology Co., Ltd, Shenzhen City Guangdong 518000 (CN)
(72) Inventor: ZHANG, Jiachao, Shenzhen City (CN); LI, Hongju, Shenzhen City (CN); ZHAO, Xin, Shenzhen City (CN); LI, Xinkun, Shenzhen City (CN)
(74) Representative: Ran, Handong

(57) **Abstract**

This application discloses a LiDAR, an autonomous driving system and a movable device. The LiDAR includes a housing, a light transmitting plate, an emitting component, a receiving component, and a functional board. An emitting board of the emitting component is on one side of an emitting lens that is far away from the light transmitting plate. A receiving board of the receiving component is on one side of a receiving lens that is far away from the light transmitting plate. The functional board is between the emitting board and the emitting lens. The functional board avoids an optical transmission path between the emitting board and the emitting lens. The functional board is in contact with the housing. This application is capable of dissipating heat generated by electronic components on one side of the housing that is close to the light transmitting plate, and dissipating heat generated by the emitting board and the receiving board on the other side of the housing that is far away from the light transmitting plate, so that the thermal power distribution of the LiDAR is relatively uniform, and the heat dissipation efficiency of the LiDAR is improved.

## Description

### TECHNICAL FIELD

The present application relates to the technical field of laser ranging, particularly to a LiDAR, an autonomous driving system, and a movable device.

### BACKGROUND

LiDAR is a system that detects the position, velocity, and other characteristics of a target by emitting a laser beam. The system emits detection light towards the target, and then compares the received echo light reflected from the target with the local oscillator light. After processing, relevant information about the target, such as distance, azimuth, height, speed, attitude, and even shape parameters, can be obtained.

In order to achieve long-range ranging capability and obtain a high point cloud scanning frame rate, the emitting sensor of the emitting board in the LiDAR usually operates at limit emission power and frequency in the design, so its heating power is relatively high. And the receiving sensor, power board, and main control board in the LiDAR will also increase the output power along with the emitting sensor to meet the ranging needs of the whole machine. However, during the operation of the LiDAR, each component continuously emits heat. If the heat is not dissipated in time, as the LiDAR heats up, the resistance and current of the components will increase, and the efficiency will decrease. In severe cases, it may even lead to burnout.

A typical LiDAR usually includes multiple rigid circuit boards such as emitting boards, receiving boards, and power boards, which are usually fixedly installed inside the LiDAR. Different rigid circuit boards are usually connected via flexible circuit boards or floating connectors to achieve signal interaction. However, flexible circuit boards are not easy to fix and are prone to excitation, and floating connectors are relatively expensive.

### SUMMARY

Embodiments of this application provide a LiDAR, an autonomous driving system, and a movable device, to resolve a problem that in an operation process of the LiDAR, each device continuously emits heat, if the heat cannot be dissipated in a timely manner, with the temperature rise of the LiDAR, the resistance and the current of the device increase, efficiency is reduced, and in severe cases, burning may occur.

In a first aspect, embodiments of this application provide a LiDAR, including:
a housing, having a receiving cavity and an opening in communication with the receiving cavity;
a light transmitting plate, covering the opening and connected to the housing;
an emitting component, located in the receiving cavity and including an emitting lens and an emitting board, wherein the emitting board is located on a side of the emitting lens away from the light transmitting plate;
a receiving component, located in the receiving cavity and including a receiving lens and a receiving board, wherein the receiving board is located on a side of the receiving lens away from the light transmitting plate; and
a functional board, located in the receiving cavity, on a side of the emitting board close to the light transmitting plate and a side of the receiving board close to the light transmitting plate, wherein the functional board is in contact with the housing and is configured to avoid an optical transmission path between the emitting board and the emitting lens and to further avoid an optical transmission path between the receiving lens and the receiving board.

In a second aspect, this application provides an autonomous driving system, including the LiDAR.

In a third aspect, this application provides a movable device, including the LiDAR; or including the autonomous driving system.

The LiDAR, the autonomous driving system, and the movable device in this application set the functional board on the side of the emitting board and the side of the receiving board close to the light transmitting plate, which is beneficial to heat dissipation of the electronic components of the functional board on the side of the housing close to the light transmitting plate, while the heat generated by the emitting board and the receiving board is dissipated on the side of the housing away from the light transmitting plate. The functional board is usually set on the side of the emitting board away from the light transmitting plate or the side of the receiving board away from the light transmitting plate, so that the heat of the emitting board, the receiving board, the functional board and other heating devices is mainly concentrated on the side of the housing away from the light transmitting plate, which can make the thermal power distribution of the LiDAR relatively uniform and improve the heat dissipation efficiency of the LiDAR.

Embodiments of this application disclose a LiDAR, an autonomous driving system, and a movable device. The LiDAR includes a housing, a first rigid circuit board, a second rigid circuit board, a flexible circuit board, a first positioning member, and a second positioning member. A portion of a projection of the second rigid circuit board on a first plane overlaps with a portion of a projection of the first rigid circuit board on the first plane. The flexible circuit board includes a first bent portion and a second bent portion. The first positioning member positions the first bent portion. The second positioning member positions the second bent portion. The first bent portion and the second bent portion can provide space for the assembly of the first rigid circuit board and the second rigid circuit board, which is more convenient to assemble. The first positioning member and the second positioning member are beneficial for controllable bending and fixing of the flexible circuit board, ensuring the stacking form of the first rigid circuit board and the second rigid circuit board, and avoiding the generation of excitation of the flexible circuit board, thereby improving the mounting stability of the flexible circuit board, the first rigid circuit board, and the second rigid circuit board in the LiDAR.

Embodiments of this application provide a LiDAR, an autonomous driving system, and a movable device, to resolve a problem that flexible circuit board is not easy to fix and is prone to excitation, and the floating connector has a high cost.

In a fourth aspect, the embodiments of this application provide a LiDAR, including a housing and a plurality of mounting components. Each mounting component includes: a first rigid circuit board, where the first rigid circuit board is connected to the housing; a second rigid circuit board, where the second rigid circuit board is connected to the housing, the second rigid circuit board is spaced apart from the first rigid circuit board in a first direction, a portion of a projection of the second rigid circuit board on a first plane overlapping a portion of a projection of the first rigid circuit board on the first plane, the first direction is perpendicular to a surface of the first rigid circuit board, the first plane being parallel to the surface of the first rigid circuit board; a flexible circuit board, where the flexible circuit board is electrically connected to the first rigid circuit board and the second rigid circuit board, the flexible circuit board includes a first bent portion and a second bent portion, the first bent portion and the second bent portion are provided along an extending direction of the flexible circuit board, the first bent portion and the second bent portion are bent in opposite directions, the first bent portion defines a first interval, and the second bent portion defines a second interval; a first positioning member, where the first positioning member is located in the first interval and in contact with the first bent portion to position the first bent portion; and a second positioning member, where the second positioning member is located in the second interval and in contact with the second bent portion to position the second bent portion.

In an embodiment, the first structural part constitutes at least a portion of the first bent portion; and/or the first structural part constitutes at least a portion of the second bent portion.

In an embodiment, the first positioning member and the second positioning member are elastic, and the first positioning member and/or the second positioning member are in a compressed state.

In an embodiment, the LiDAR further comprises an emitting board and a receiving board, wherein one of the first rigid circuit board and the second rigid circuit board is the emitting board, and the other of the first rigid circuit board and the second rigid circuit board is the receiving board.

In an embodiment, the LiDAR further comprises: a power board, the power board being electrically connected to the emitting board and the receiving board, the emitting board and the receiving board being located on the same side of the power board along the first direction, at least a portion of a projection of the emitting board on the first plane overlapping a portion of a projection of the power board on the first plane, at least a portion of a projection of the receiving board on the first plane overlapping a portion of a projection of the power board on the first plane.

In an embodiment, the LiDAR further comprises: a floating connector, the floating connector being mounted on one side of the power board close to the receiving board, the floating connector being electrically connected to the power board, a projection of the floating connector on the first plane being outside a projection of the emitting board on the first plane, a projection of the floating connector on the first plane being outside a projection of the receiving board on the first plane.

In an embodiment, the LiDAR further comprises: a light transmitting plate, wherein the housing is provided with an opening, and the light transmitting plate covers the opening and is connected to the housing; an emitting component, comprising an emitting board and an emitting lens, the emitting board being located on one side away from the light transmitting plate of the emitting lens; a receiving component, comprising a receiving board and a receiving lens, the receiving board being located on one side away from the light transmitting plate of the receiving lens, one of the first rigid circuit board and the second rigid circuit board being the receiving board; and a power board, electrically connected to the emitting board and the receiving board, and the other of the first rigid circuit board and the second rigid circuit board being the power board.

In an embodiment, the power board is located on the side of the emitting board close to the light transmitting plate, the power board being located on the side of the receiving board close to the light transmitting plate; and/or the emitting board and the receiving board share the same substrate.

In an embodiment, the LiDAR further comprises: a connecting board, the connecting board being connected to the housing, the connecting board being located between the receiving board and the power board along the first direction, the first positioning member being connected to the receiving board and the power board, one of the second positioning member being connected to the connecting board.

In an embodiment, the first positioning member is connected to the first rigid circuit board, and the second positioning member is connected to the second rigid circuit board; and/or wherein the LiDAR further comprises a third rigid circuit board, the third rigid circuit board being connected to the housing, the third rigid circuit board being located in the first direction between the first rigid circuit board and the second rigid circuit board, the first positioning member being connected to one of the first rigid circuit board and the second rigid circuit board, and the second positioning member being connected to the third rigid circuit board.

In an embodiment, the first rigid circuit board has a first side wall, the flexible circuit board is connected to the first side wall, the first positioning member is connected to the first rigid circuit board, the first positioning member comprises a first positioning part, the first positioning part is located on one side of the first side wall of the first rigid circuit board, and the flexible circuit board bypasses the first positioning part on the side away from the first side wall; and/or the second rigid circuit board has a second side wall, the flexible circuit board is connected to the second side wall, the second positioning member is connected to the second rigid circuit board, the second positioning member comprises a second positioning part, the second positioning part is located on one side of the second side wall of the second rigid circuit board, and the flexible circuit board bypasses the second positioning part on the side away from the second side wall.

In an embodiment, the housing is provided with at least one first fixing column and at least one second fixing column, the first rigid circuit board is provided with a first mounting hole corresponding to the first fixing column, the first fixing column is located in the first mounting hole and connected to the first rigid circuit board, the second rigid circuit board is provided with a second mounting hole corresponding to the second fixing column, the second fixing column is located in the second mounting hole and connected to the second rigid circuit board, and at least one first fixing column and at least one second fixing column share the same fixing column.

In an embodiment, the LiDAR further comprises: a light transmitting plate, the housing comprises a first housing and a second housing, the first housing provided with an opening, the light transmitting plate covering the opening and connected to the first housing, the second housing being connected to a side of the first housing away from the opening, the first housing being provided with the at least one first fixing column and the at least one second fixing column.

In a fifth aspect, embodiments of this application provide an autonomous driving system, including the LiDAR.

In a sixth aspect, embodiments of this application provide a movable device, including the LiDAR; or including the autonomous driving system.

The LiDAR, the autonomous driving system, and the movable device in this application set the second rigid circuit board to overlap with a portion of a projection of the first rigid circuit board on the first plane, which is beneficial for compressing the size of the first rigid circuit board and the second rigid circuit board in a direction parallel to the first plane, and then reducing the size of the LiDAR in a direction parallel to the first plane, thereby achieving miniaturization of the LiDAR. The flexible circuit board that connects the first rigid circuit board and the second rigid circuit board is designed to include the first bent portion and the second bent portion in opposite bending directions, during the assembly of the first rigid circuit board and the second rigid circuit board with the housing, the reciprocating first bent portion and the second bent portion can provide space for the assembly of the first rigid circuit board and the second rigid circuit board with the housing, which is more convenient to assemble. The setting of the first positioning member and the second positioning member is beneficial for controllable bending and fixing of the flexible circuit board, ensuring the stacking form of the first rigid circuit board and the second rigid circuit board, and can avoid the large excitation of the flexible circuit board due to vibration, thereby improving the mounting stability of the flexible circuit board in the LiDAR and improving the connection stability between the flexible circuit board and the first rigid circuit board and the second rigid circuit board.

### BRIEF DESCRIPTION OF DRAWINGS

To more clearly describe the technical solution in the embodiments of this application, a brief description of the drawings required in the embodiments or the related art description to be used below is given. The following description of the drawings is only some embodiments of this application.
FIG. 1 is a schematic structural diagram of a movable device according to an embodiment;
FIG. 2 is a schematic structural diagram of a movable device according to an embodiment;
FIG. 3 is a schematic sectional structure diagram of LiDAR according to an embodiment;
FIG. 4 is a schematic sectional structure diagram of LiDAR according to another embodiment;
FIG. 5 is a schematic exploded structure diagram of LiDAR shown in FIG. 4 in a perspective view;
FIG. 6 is a schematic exploded structure diagram of LiDAR shown in FIG. 4 in another perspective view;
FIG. 7 is a schematic three-dimensional structural diagram of a first housing, an emitting board, a receiving board, a power board, and a connecting board in LiDAR according to an embodiment;
FIG. 8 is a schematic sectional structural diagram of LiDAR shown in FIG. 7;
FIG. 9 is a schematic three-dimensional structural diagram of the emitting board, the receiving board, the power board, and the connecting board in LiDAR shown in FIG. 7;
FIG. 10 is a schematic structural diagram of the emitting board and the receiving board in LiDAR shown in FIG. 7 in a front view;
FIG. 11 is a schematic sectional structural diagram of the emitting board, the receiving board, the power board, and the connecting board in LiDAR shown in FIG. 7;
FIG. 12 is a schematic structural diagram of the emitting board, the receiving board, and the main control board in LiDAR according to an embodiment;
FIG. 13 is a schematic structural diagram of LiDAR according to an embodiment;
FIG. 14 is a schematic sectional structure diagram of LiDAR according to an embodiment;
FIG. 15 is a schematic three-dimensional structural diagram of a part of LiDAR shown in FIG. 4;
FIG. 16 is a schematic front view structural diagram of a part of LiDAR shown in FIG. 4;
FIG. 17 is a schematic sectional structural diagram of a part of LiDAR shown in FIG. 4;
FIG. 18 is a schematic sectional structural diagram of another part of LiDAR shown in FIG. 4;
FIG. 19 is a schematic sectional structural diagram of a part of LiDAR shown in FIG. 18;
FIG. 20 is a schematic exploded structural diagram of LiDAR shown in FIG. 4 in a perspective view;
FIG. 21 is a schematic exploded structural diagram of LiDAR shown in FIG. 4 in another perspective view.
Reference signs in the drawings: 1, movable device; 2, autonomous driving system; 3, LiDAR; 31, housing; 311, receiving cavity; 312, opening; 313, first housing; 3131, first cavity; 3132, first step; 3133, first surface; 314, second housing; 3141, second cavity; 3151, first convex platform; 3152, second convex platform; 3153, third convex platform; 316, heat dissipation fin; 317, sealing ring; 318, first fixing column; 3181, first adhesive layer; 319, second fixing column; 3191, second adhesive layer; 310, reinforcing rib; 32, emitting component; 321, emitting lens; 3211, first end face; 3212, second end face; 3213, emitting lens barrel; 3214, emitting lens piece; 322, emitting board; 3221, first mounting hole; 3222, first heat dissipation hole; 323, emitting shielding cover; 3231, first light passing path; 33, receiving component; 331, receiving lens; 3311, third end face; 3312, fourth end face; 3313, receiving lens barrel; 3314, receiving lens piece; 332, receiving board; 3321, second mounting hole; 3322, second heat dissipation hole; 333, receiving shielding cover; 3331, second light passing path; 34, light transmitting plate; 35, functional board; 351, first avoidance region; 352, second avoidance region; 353, substrate; 3531, first surface; 3532, second surface; 354, electronic component; 355, power board; 356, main control board; 36, flexible circuit board; 361, first bent portion; 3611, first interval; 362, second bent portion; 3621, second interval; 363, first structural part; 37, first positioning member; 371, first positioning part; 38, second positioning member; 381, second positioning part; 39, connecting board; 41, first rigid circuit board; 411, first side wall; 42, second rigid circuit board; 421, second side wall; 43, third rigid circuit board; 44, bracket; 45, mounting frame; x, first direction.

### DETAILED DESCRIPTION

To make objectives, technical solutions, and advantages of the present application clearer, the present application is described in further detail below with reference to the drawings.

When the following description involves the drawings, unless otherwise indicated, the same reference numerals in different drawings denote the same or similar elements. The implementations described in the following exemplary embodiments do not represent all the implementations consistent with the present application. On the contrary, they are only examples of devices and methods consistent with some aspects of the present application as detailed in the appended claims.

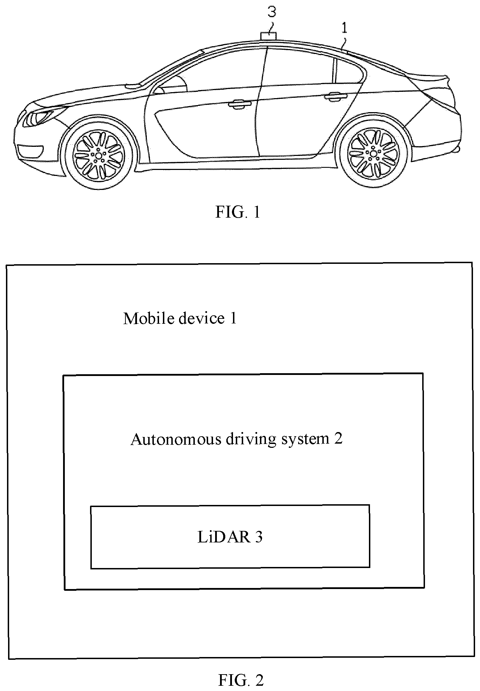

Referring to FIG. 1 and FIG. 2, an embodiment of this application provides a movable device 1. The movable device 1 includes a LiDAR 3. Or, the movable device 1 includes an autonomous driving system 2. The movable device 1 can be any device such as a car, a drone, or a robot that includes a LiDAR 3 or an autonomous driving system 2. When the movable device 1 includes the autonomous driving system 2, the autonomous driving system 2 includes the LiDAR 3.

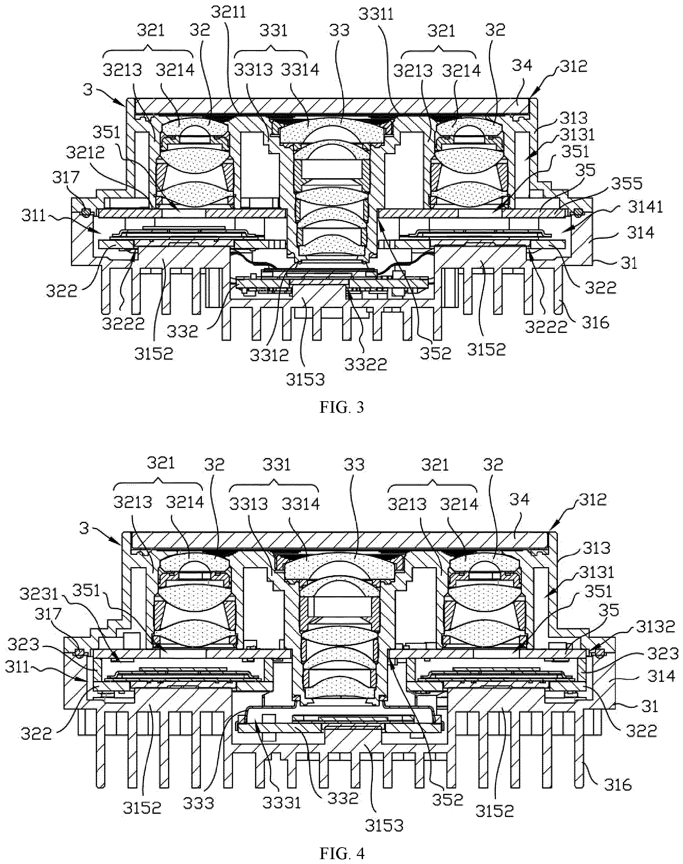

Referring to FIG. 3, the LiDAR 3 includes an emitting component 32 and a receiving component 33. The emitting component 32 is configured to output detection light to detect a target object in a detection region, and the receiving component 33 is configured to receive an echo light reflected by the detection light from the target object. An electrical signal corresponding to the echo light is output. The electrical signal is properly processed by a signal processing unit in the LiDAR 3 to form a point cloud. The point cloud is further processed to obtain parameters such as a distance, an azimuth, a height, a speed, a posture, and a shape of the target object, thereby implementing the laser detection function, and can be applied to scenarios such as navigation, obstacle identification, ranging, speed measurement, and autonomous driving of products such as a car, a robot, a logistics vehicle, and a patrol vehicle.

The LiDAR 3 can be used in other application scenarios in addition to a laser detection technical field, for example, in a technical field such as part diameter detection, surface roughness detection, strain detection, displacement detection, vibration detection, speed detection, distance detection, acceleration detection, and object shape detection.

Referring to FIG. 3 to FIG. 6, the LiDAR 3 includes a housing 31, the emitting component 32, the receiving component 33, a light transmitting plate 34, and a functional board 35.

The housing 31 has a receiving cavity 311 and an opening 312 in communication with the receiving cavity 311. The light transmitting plate 34 covers the opening 312 and is connected to the housing 31. The emitting component 32 is located in the receiving cavity 311. The emitting component 32 includes an emitting lens 321 and an emitting board 322. The emitting board 322 is located on a side of the emitting lens 321 away from the light transmitting plate 34. The receiving component 33 is located in the receiving cavity 311. The receiving component 33 includes a receiving lens 331 and a receiving board 332. The receiving board 332 is located on a side of the receiving lens 331 away from the light transmitting plate 34. The functional board 35 is located in the receiving cavity 311. The functional board 35 is located on a side of the emitting board 322 close to the light transmitting plate 34. The functional board 35 is located on a side of the receiving board 332 close to the light transmitting plate 34. The functional board 35 avoids an optical transmission path between the emitting board 322 and the emitting lens 321. The functional board 35 also avoids an optical transmission path between the receiving lens 331 and the receiving board 332. The functional board 35 is in contact with the housing 31. Wherein, the functional board 35 avoids the optical transmission path between the emitting board 322 and the emitting lens 321, which can ensure that the detection light emitted by the emitting board 322 reaches the emitting lens 321 smoothly. The functional board 35 avoids the optical transmission path between the receiving lens 331 and the receiving board 332, which can ensure that the echo light output by the receiving lens 331 reaches the receiving board 332 smoothly. The functional board 35 is in contact with the housing 31 to facilitate the transfer of heat generated by the electronic components 354 of the functional board 35 towards the housing 31.

In some examples, due to the limitation of the entire structure, a heat generating element on a circuit board is mostly concentrated on one side of the housing away from the light transmitting plate, to shorten a heat dissipation path, the heat generating element dissipates heat directly on the side of the housing away from the light transmitting plate, which causes a concentration of local heat power density, and increases the heat dissipation load on the side of the housing away from the light transmitting plate, thereby making the temperature non-uniform. However, in embodiments of the application, the functional board 35 is arranged on the side of the emitting board 322 close to the light transmitting plate 34 and the side of the receiving board 332 close to the light transmitting plate 34, so that heat generated by electronic elements on the functional board 35 is dissipated on the side of the housing 31 close to the light transmitting plate 34, while heat generated by the emitting board 322 and the receiving board 332 is dissipated on the side of the housing 31 away from the light transmitting plate 34, thereby making a distribution of local heat relatively uniform and improving heat dissipation efficiency of the LiDAR 3.

The functional board 35 can be any circuit board in the LiDAR 3 except the emitting board 322 and the receiving board 332; for example, the functional board 35 can include at least one of a power board 355 and a main control board 356.

In an embodiment, the functional board 35 is selected as the power board 355, and a size of the power board 355 can be designed to be roughly compatible with a size of the emitting board 322 in the housing close to the side of the light transmitting plate, or the size of the power board 355 can be designed to be roughly compatible with a size of the receiving board 332 in the housing close to the side of the light transmitting plate, so that the power board 355 is arranged at the front, which can be based on the original size of the LiDAR 3, and even the power board 355 is arranged at the front, which can compress the size of the LiDAR 3 in the direction perpendicular to the light transmitting plate 34, and realize the miniaturization of the LiDAR 3.

The power board 355 is provided with a power circuit. The power board 355 can be provided with all power circuits in the LiDAR 3, or the power board 355 can also be provided with partial power circuits in the LiDAR 3.

The functional board 35 may be spaced apart from the emitting board 322 and/or the receiving board 332 in a direction perpendicular to the light transmitting plate 34 and/or a direction parallel to the light transmitting plate 34, to improve heat dissipation performance of the LiDAR 3. A distance between the functional board 35 and the emitting board 322, and a distance between the functional board 35 and the receiving board 332 can be adjusted flexibly.

If the functional board 35 is located on a side of the emitting board 322 that is close to the light transmitting plate 34, the functional board 35 may be located between the emitting board 322 and the emitting lens 321, or the functional board 35 may be located between a first end face 3211 of the emitting lens 321 facing the light transmitting plate 34 and a second end face 3212 of the emitting lens 321 facing the emitting board 322. If the functional board 35 is located between the first end face 3211 and the second end face 3212, a space utilization efficiency of the emitting lens 321 around the side of the housing 31 can be improved, and the volume of the LiDAR 3 can be reduced.

If the functional board 35 is located on a side of the emitting board 322 that is close to the light transmitting plate 34, a projection of the functional board 35 on the light transmitting plate 34 can be on one side of a projection of the emitting lens 321 on the light transmitting plate 34. In this case, the functional board 35 does not block an optical transmission path between the emitting board 322 and the emitting lens 321. In addition, if the functional board 35 is located on a side of the emitting board 322 that is close to the light transmitting plate 34, a projection of the functional board 35 on the light transmitting plate 34 can also surround at least a part of a projection of the emitting lens 321 on the light transmitting plate 34. In this case, the functional board 35 is provided with a first avoidance region 351. If the functional board 35 is located between the emitting lens 321 and the emitting board 322, the first avoidance region 351 is set to facilitate the detection light emitted by the emitting board 322 to pass through, so that the detection light can smoothly reach the emitting lens 321. If the functional board 35 is located between the first end face 3211 and the second end face 3212, the first avoidance region 351 is set to facilitate the assembly of the functional board 35 and the emitting lens 321 in the housing 31, for example, the emitting lens 321 can pass through the first avoidance region 351 of the functional board 35.

The first avoidance region 351 may be a notch at an edge of the functional board 35, or the first avoidance region 351 may be a through-hole on an inner side of the functional board 35.

If the functional board 35 is located on a side of the emitting board 322 that is close to the light transmitting plate 34, the emitting lens 321 may be in contact with the functional board 35, to position the mounting position of the emitting lens 321 via the functional board 35. If the functional board 35 is located between the emitting lens 321 and the emitting board 322, a side of the emitting lens 321 facing the emitting board 322 may be in contact with the functional board 35. If the functional board 35 is located between the first end face 3211 and the second end face 3212, a periphery of the emitting lens 321 may have a step surface (not shown in the figure), and the step surface of the emitting lens 321 may be in contact with the functional board 35.

The emitting lens 321 can include an emitting lens barrel 3213 and at least one emitting lens piece 3214 provided in the emitting lens barrel 3213, and the emitting lens 321 in contact with the functional board 35 means that the emitting lens barrel 3213 in contact with the functional board 35.

The emitting lens barrel 3213 can be used to mount the emitting lens piece 3214, and the emitting lens barrel 3213 can be an integrally formed structure with the part of the housing 31, to simplify the assembly process of the emitting lens barrel 3213 and the housing 31, improve the assembly efficiency, reduce the distance between the emitting lens barrel 3213 and the receiving lens barrel 3313, and reduce the volume of the LiDAR 3. The emitting lens piece 3214 can be any lens with refractive power, for example, the emitting lens piece 3214 can be a convex lens, a concave lens, and the like. The emitting lens 321 can include a spacer ring, a locking ring, and the like, where the spacer ring is used to support the emitting lens piece 3214 and control the distance between two adjacent emitting lens pieces 3214, and the locking ring is used to lock and fix the emitting lens piece 3214.

The emitting lens barrel 3213 can in contact with the light transmitting plate 34 to improve the mounting stability of the light transmitting plate 34.

The emitting component 32 can also include an emitting shielding cover 323 sleeved on the emitting board 322, and the emitting shielding cover 323 can have a first light passing path 3231. If the functional board 35 is located between the emitting lens 321 and the emitting board 322, the emitting shielding cover 323 can be connected between the functional board 35 and the emitting board 322, and the first light passing path 3231 can communicate with the first avoidance region 351, so that the detection light emitted by the emitting board 322 can enter the emitting lens 321 after passing through the first light passing path 3231 and the first avoidance region 351, and is not easily scattered outward, which reduce light loss. The emitting shielding cover 323 can be connected with the emitting board 322 via an adhesive, and the light passing path can in connect with the functional board 35. The emitting shielding cover 323 can be a light-shielding foam, so that the emitting shielding cover 323 can be connected to the functional board 35 by pressing and deforming, to ensure sufficient assembly space.

If the functional board 35 is located between the first end face 3211 and the second end face 3212, the emitting shielding cover 323 can be connected between the emitting board 322 and the emitting lens 321, and the first light passing path 3231 can communicate with an incident light hole of the emitting lens 321, so that the detection light emitted by the emitting board 322 can directly enter the emitting lens barrel 3213 after passing through the first light passing path 3231. The emitting shielding cover 323 can be connected to the emitting board 322 via welding, and a sealant can be provided at the connection to prevent light leakage, and the emitting shielding cover 323 can be connected to the emitting lens 321 via the sealant, to ensure sufficient assembly space.

In some embodiments of this application, the functional board 35 is located between the emitting lens 321 and the emitting board 322, and the second end face 3212 of the emitting lens 321 in connect with the functional board 35.

If the functional board 35 is on the side of the receiving board 332 that is closer to the light transmitting plate 34, the functional board 35 can be located between the receiving board 332 and the receiving lens 331, or the functional board 35 can be located between a third end surface 3311 of the receiving lens 331 that faces the light transmitting plate 34 and a fourth end surface 3312 of the receiving lens 331. If the functional board 35 is between the third end surface 3311 and the fourth end surface 3312 of the receiving lens 331, a space utilization of the periphery of the receiving lens 331 in the housing 31 can be improved, and the volume of the LiDAR 3 can be reduced.

If the functional board 35 is on the side of the receiving board 332 that is closer to the light transmitting plate 34, a projection of the functional board 35 on the light transmitting plate 34 can be on the same side of a projection of the receiving lens 331 on the light transmitting plate 34, and in this case, the functional board 35 does not block an optical transmission path between the receiving board 332 and the receiving lens 331. In addition, if the functional board 35 is on the side of the receiving board 332 that is closer to the light transmitting plate 34, a projection of the functional board 35 on the light transmitting plate 34 can surround at least a part of a projection of the receiving lens 331 on the light transmitting plate 34, and in this case, the functional board 35 is provided with a second avoidance region 352. If the functional board 35 is between the receiving board 332 and the receiving lens 331, the second avoidance region 352 is set to allow the echo light output by the receiving lens 331 to pass through, and reach the receiving board 332 smoothly. If the functional board 35 is between the third end surface 3311 and the fourth end surface 3312 of the receiving lens 331, the second avoidance region 352 is set to facilitate the assembly of the functional board 35 and the receiving lens 331 in the housing 31.

The second avoidance region 352 can be an edge notch of the functional board 35, and the second avoidance region 352 can also be a through-hole on an inner side of the functional board 35.

If the functional board 35 is on a side of the receiving board 332 that is close to the light transmitting plate 34, the receiving lens 331 can be connected to the functional board 35, to position the mounting position of the receiving lens 331. If the functional board 35 is located between the receiving board 332 and the receiving lens 331, the side of the receiving lens 331 facing the receiving board 332 can be connected to the functional board 35; if the functional board 35 is located between the third end face 3311 and the fourth end face 3312 of the receiving lens 331, a step surface of the receiving lens 331 can be provided, and the step surface of the receiving lens 331 can be connected to the functional board 35.

The receiving lens 331 can include a receiving lens barrel 3313 and at least one receiving lens piece 3314 provided in the receiving lens barrel 3313, and the receiving lens 331 in connect with the functional board 35 means that the receiving lens barrel 3313 in contact with the functional board 35.

The receiving lens barrel 3313 is configured to mount the receiving lens piece 3314. The receiving lens barrel 3313 can be an integral structure with the housing 31, to simplify an assembly process of the receiving lens barrel 3313 and the housing 31, improve assembly efficiency, reduce a distance between the emitting lens barrel 3213 and the receiving lens barrel 3313, and reduce the volume of the LiDAR 3.

The receiving lens 3314 can be any lens with a refractive power, for example, the receiving lens 3314 can be a convex lens, a concave lens and the like. The receiving lens 331 can also include a spacer ring, a locking ring and the like, where the spacer ring is used to support the receiving lens 3314 and control a distance between the receiving lens 3314 and an adjacent receiving lens 3314, and the locking ring is used to lock and support the receiving lens 3314.

Where, the emitting lens barrel 3213 face the first end surface 3211 of the light transmitting plate 34, the receiving lens barrel 3313 face the third end surface 3311 of the light transmitting plate 34, and the surface of the housing 31 facing the light transmitting plate 34 can be in the same plane and be connected to each other, to increase the path width of the sealed adhesive between the plane and the light transmitting plate 34, reduce the possibility of water vapor penetration, and reduce the risk of condensation. In addition, the LiDAR 3 can also be provided with a waterproof and breathable valve, which can timely disperse the accumulated water vapor inside the LiDAR 3 and balance the internal and external air pressure. The waterproof and breathable valve can be attached to the second housing 314 via the pressure-sensitive adhesive.

The receiving lens barrel 3313 can in connect with the light transmitting plate 34 to improve mounting stability of the light transmitting plate 34.

The receiving component 33 can also include the receiving shielding cover 333 sleeved on the receiving board 332, and the receiving shielding cover 333 can have a second light passing path 3331. If the functional board 35 is located between the receiving lens 331 and the receiving board 332, the receiving shielding cover 333 can be connected between the functional board 35 and the receiving board 332, and the second light passing path 3331 can communicate with the second avoidance region 352, so that the echo light output by the receiving lens 331 can pass through the second avoidance region 352 and the second light passing path 3331 to reach the receiving board 332, thereby avoiding interference between the echo light and other stray light. The receiving shielding cover 333 can be connected to the receiving board 332 via an adhesive, and in connect with the functional board 35. At this time, the receiving shielding cover 333 can be a light-shielding sponge, so that the receiving shielding cover 333 can be connected to the functional board 35 by pressing and deforming, to ensure sufficient assembly space. If the functional board 35 is located between the third end surface 3311 and the fourth end surface 3312, the receiving shielding cover 333 can be connected between the receiving board 332 and the receiving lens 331, and the second light passing path 3331 can directly communicate with the light-emitting hole of the receiving lens 331, so that the echo light output by the receiving lens 331 can directly reach the receiving board 332 after passing through the second light passing path 3331. The receiving shielding cover 333 can be connected to the receiving board 332 via welding, and a sealing adhesive can be provided at a connection of the two to prevent light leakage. The receiving shielding cover 333 can be connected to the receiving lens 331 via a sealing adhesive, to ensure sufficient assembly space.

In some embodiments of this application, the functional board 35 is located between the third end surface 3311 and the fourth end surface 3312, the receiving lens barrel 3313 of the receiving lens 331 passes through the second avoidance region 352 of the functional board 35, the receiving lens barrel 3313 in connect with the light transmitting plate 34, and the receiving lens 331 is provided with a step surface facing away from the light transmitting plate 34, and the step surface in connect with the functional board 35.

The housing 31 includes a first housing 313 and a second housing 314. The first housing 313 is provided with an opening 312, and the functional board 35 is in contact with the first housing 313. The second housing 314 is connected to one side of the first housing 313 away from the opening 312. The emitting board 322 and the receiving board 332 are both in contact with the second housing 314. The housing 31 is split into the first housing 313 and the second housing 314, which is convenient for assembling internal components such as the emitting component 32, the receiving component 33, and the functional board 35. The functional board 35 is in contact with the first housing 313, which is convenient for the heat generated by the heating element on the functional board 35 to be transferred to the first housing 313. The emitting board 322 and the receiving board 332 are both in contact with the second housing 314, which is convenient for the heat generated by the emitting board 322 and the receiving board 332 to be transferred to the second housing 314, thereby improving the uniform distribution of the heat power and the heat dissipation efficiency of the LiDAR 3.

The first housing 313 may have a first cavity 3131, and the second housing 314 may have a second cavity 3141 communicated with the first cavity 3131. The emitting board 322 and the receiving board 332 may be located in the second cavity 3141. The accommodating cavity 311 includes the first cavity 3131 and the second cavity 3141. The functional board 35 may be located in the first cavity 3131, or may be located at the junction of the first cavity 3131 and the second cavity 3141. The functional board 35 in contact with the first housing 313. The first housing 313 or the second housing 314 may also be generally plate-shaped, without forming a cavity.

The above mentioned integrally formed structure of the emitting lens barrel 3213 and the part of the housing 31 may be an integrally formed structure of the emitting lens barrel 3213 and the first housing 313, and the integrally formed structure of the receiving lens 331 and the part of the housing 31 may be an integrally formed structure of the receiving lens barrel 3313 and the first housing 313.

The first housing 313 may be provided with a first step 3132, and the functional board 35 may be located on the first step 3132, which is convenient for mounting and positioning the functional board 35 and the first housing 313. The functional board 35 may be in contact with a step wall of the first step 3132, thereby improving the connection stability between the functional board 35 and the first housing 313.

The first housing 313 may have a first surface 3133 facing the second housing 314. The first step 3132 may be formed on the first surface 3133, which is convenient for mounting the functional board 35 on the first step 3132 from one side of the second housing 314 facing the first housing 313. The thickness of the functional board 35 in a direction perpendicular to the first surface 3133 may be greater than, less than, or equal to the thickness of the first step 3132 in a direction perpendicular to the first surface 3133.

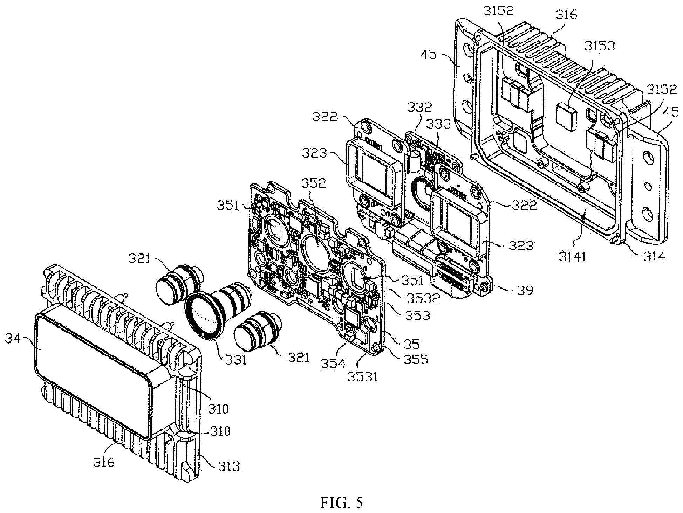

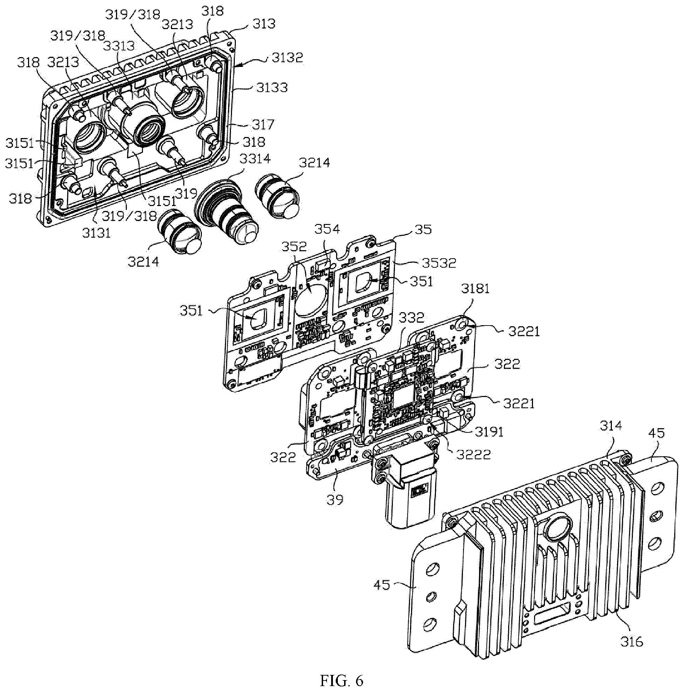

Referring to FIG. 5 and FIG. 6, the functional board 35 may include a substrate 353 and electronic elements 354. The substrate 353 may have a first board surface 3531 facing the light transmitting plate 34 and a second board surface 3532 away from the first board surface 3531. The first board surface 3531 and/or the second board surface 3532 may be mounted with the electronic elements 354. The substrate 353 and the electronic elements 354 may avoid an optical transmission path between the emitting board 322 and the emitting lens 321, and an optical transmission path between the receiving lens 331 and the receiving board 332.

The at least some electronic elements 354 on the functional board 35 can be in contact with the housing 31 via a thermal conductive gel, so that heat generated by the at least some electronic elements 354 can be transferred to the housing 31 via the thermal conductive gel, thereby shortening the heat transfer path and helping to enhance heat dissipation. The at least some electronic elements 354 on the functional board 35 can be in contact with the first housing 313 via the thermal conductive gel, thereby facilitating the transfer of heat generated by the electronic elements 354 on the functional board 35 to the first housing 313. The thermal conductive gel can achieve a higher thermal conductivity for heat transfer; and the thermal conductive gel has a good elasticity and compression deformation effect after solidification, and does not generate a large amount of thermal stress, which can prevent a change in position of the functional board 35 due to thermal stress deformation.

In some embodiments, the housing 31 can be provided with a first convex platform 3151 at a location of the electronic elements 354 that need heat conduction, and the first convex platform 3151 is in contact with the corresponding electronic elements 354 via a thermal conductive gel. The thermal conductive gel can be first coated on the electronic elements 354 on the functional board 35 that need heat conduction, and then the functional board 35 can be mounted on the housing 31, so that the thermal conductive gel on the electronic elements 354 that need heat conduction is in contact with the corresponding first convex platform 3151. The first convex platform 3151 can be provided on the first housing 313. The first convex platform 3151 facilitates contact with the electronic elements 354 that require heat conduction on the functional board 35, without the entire housing 31 being in contact with the functional board 35.

In the functional board 35, the electronic elements 354 in contact with the housing 31 via the thermal conductive gel can be the electronic elements 354 that are prone to generate heat, or can be any electronic elements 354.

To increase the thermal conductivity of the receiving board 332/emitting board 322 in the thickness direction, the receiving board 332/emitting board 322 can be provided with a through-hole, and the through-hole can embed a thermal conductive material with better thermal conductivity, and the thermal conductive material can quickly absorb and dissipate heat, to prevent heat from accumulating at the receiving board 332/emitting board 322, leading to device damage or low-power operation. The thermal conductive material can be copper or the like with a higher thermal conductivity.

The receiving board 332/emitting board 322 can be provided with a through-hole, for example, a through-hole can be provided in a central region of the receiving board 332/emitting board 322, and the through-hole can comprise multiple pinholes.

The receiving board 332/emitting board 322 can be in contact with the housing 31 via thermal conductive gel, so that the thermal conductive material in the through-hole can transfer heat to the housing 31 via the thermal conductive gel. The receiving board 332/emitting board 322 can be in contact with the second housing 314 via the thermal conductive gel, thereby facilitating the transfer of heat generated by the receiving board 332/emitting board 322 to the second housing 314. The thermal conductive gel can achieve a higher thermal conductivity for heat transfer; and the thermal conductive gel has a good elasticity and compression deformation effect after solidification, and does not generate a large amount of thermal stress, which can prevent a change in position of the receiving board 332/emitting board 322 due to thermal stress deformation.

Referring to FIG. 3 to FIG. 5, the housing 31 (e.g., the second housing 314) may have a convex platform at the emitting board 322 and/or the receiving board 332, and the convex platform may be provided with a thermal conductive gel, so that heat can be transferred to the housing 31 via the thermal conductive gel on the corresponding convex platform of the emitting board 322 and/or the receiving board 332. Further, the emitting board 322 may be provided with a first heat dissipation hole 3222 at the position corresponding to the emitting sensor, and the housing 31 may be provided with a second convex platform 3152 at the position of the emitting sensor. The second convex platform 3152 may contact the emitting sensor by passing through the first heat dissipation hole 3222, so that heat generated by the emitting sensor can be directly transferred to the housing 31. The receiving board 332 may be provided with a second heat dissipation hole 3322 at the position corresponding to the receiving sensor, and the housing 31 may be provided with a third convex platform 3153 at the position of the receiving sensor. The third convex platform 3153 may contact the receiving sensor by passing through the second heat dissipation hole 3322, so that heat generated by the receiving sensor can be directly transferred to the housing 31.

Different thermal conductive gels can be used for different heating devices. For example, for a device with high thermal power (such as the receiving board 332), a thermal conductive gel with high thermal conductivity is used for heat conduction and heat dissipation to save cost. The thermal conductivity of the thermal conductive gel with high thermal conductivity may be greater than 10W/(m·k), and the thermal conductivity of the thermal conductive gel with low thermal conductivity may be greater than 3W/(m . k).

The housing 31 can be made of aluminum material with a thermal conductivity greater than 160W/(m·k). For example, the housing 31 can be made of die-cast aluminum material. Die-casting is a processing method with relatively low processing cost. In an embodiment, the housing 31 is made of high-thermal-conductivity die-cast aluminum HA160X material, which has a high thermal conductivity compared with the ADC 12 material, and can enhance the heat uniformity of the housing 31 and improve the heat dissipation efficiency. The housing 31 can also be processed by CNC, and the material can be A16061.

The housing 31 can be provided with a heat dissipation fin 316 to increase the heat dissipation area of the housing 31 and improve the heat dissipation effect. The heat dissipation fin 316 can be provided at multiple positions such as one side of the first housing 313 away from the second housing 314, one side of the second housing 314 away from the first housing 313, etc., to increase the heat dissipation area and improve the heat dissipation efficiency. The height and setting density of the heat dissipation fin 316 can be flexibly adjusted.

The first housing 313 and the second housing 314 can be sealingly connected to improve the sealing performance of the LiDAR 3. For example, a sealing ring 317 can be provided between the first housing 313 and the second housing 314 and connected by a screw or the like. The sealing ring 317 can be an integral molded structure with the first housing 313 or the second housing 314 to simplify the assembly process, and improve the connection reliability between the sealing ring 317 and the integrally molded first housing 313 or the second housing 314. The sealing ring 317 and the first housing 313 or the second housing 314 can be formed by a process such as two-color injection molding. The sealing ring 317 can also be connected to the first housing 313 or the second housing 314 by dispensing or welding. The sealing ring 317 can be a silicone ring, and the sealing ring 317 can also be replaced with a sealing adhesive. The sealing adhesive can be formed by dispensing.

Referring to FIG. 3 and FIG. 4, the emitting board 322 and the receiving board 332 can be separately arranged. For example, the emitting board 322 and the receiving board 332 can be arranged at intervals in a direction perpendicular to the light transmitting plate 34. A partial projection of the emitting board 322 onto the light transmitting plate 34 overlaps with a partial projection of the receiving board 332 onto the light transmitting plate 34, so that dimensions of the emitting board 322 and the receiving board 332 in a direction parallel to the light transmitting plate 34 can be reduced, and an internal space of the LiDAR 3 can be fully utilized to reduce the volume of the LiDAR 3.

An outer contour line of a projection of the emitting board 322 on the light transmitting plate 34 can be inside an outer contour line of a projection of the functional board 35 on the light transmitting plate 34. An outer contour line of a projection of the receiving board 332 on the light transmitting plate 34 can be inside an outer contour line of a projection of the functional board 35 on the light transmitting plate 34. That is, a projection of the functional board 35 on the light transmitting plate 34 can include a first part outside a projection of the emitting board 322 on the light transmitting plate 34, and a projection of the functional board 35 on the light transmitting plate 34 can include a second part outside a projection of the receiving board 332 on the light transmitting plate 34. The first part and the second part can partially overlap. A floating connector can be provided at a position corresponding to the first part or the second part of the functional board 35, so as to connect to an external power supply, a signal, and the like.

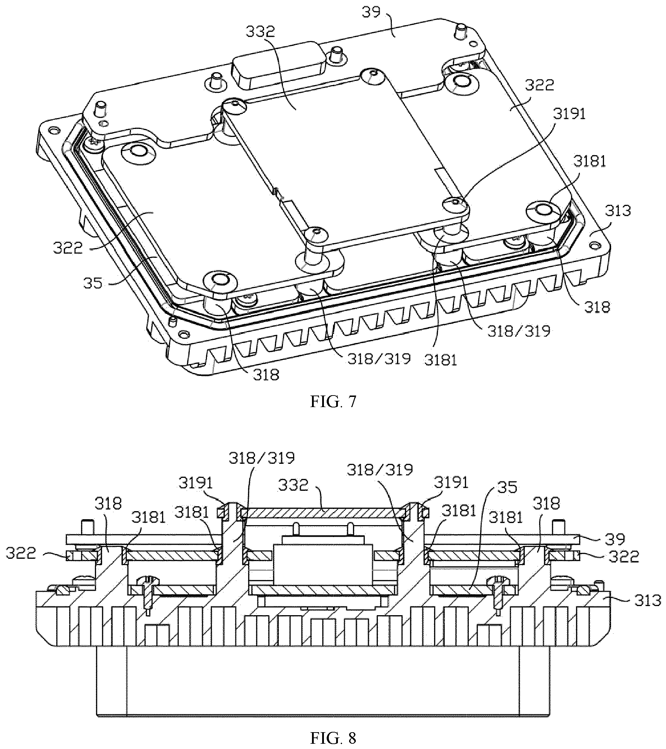

Referring to FIG. 6 and FIG. 7, the LiDAR 3 can further include a transferring board 39 located in the housing 31. At least a part of the transferring board 39 can correspond to the first part and/or correspond to the second part, to utilize the mounting space in the housing 31 and achieve a miniaturized design of the LiDAR 3. In a direction perpendicular to the light transmitting plate 34, the transferring board 39 can be located between the emitting board 322 and the receiving board 332. A part of a projection of the transferring board 39 on the functional board 35 can overlap with a part of a projection of the emitting board 322 on the functional board 35, and/or a part of a projection of the transferring board 39 on the functional board 35 can overlap with a part of a projection of the receiving board 332 on the functional board 35. The transferring board 39 can be connected to the power board 355 via the floating connector. The floating connector includes a male connector and a female connector that are adapted to be used in combination. The male connector can be provided on the power board 355, and the transferring board 39 can be provided with the female connector.

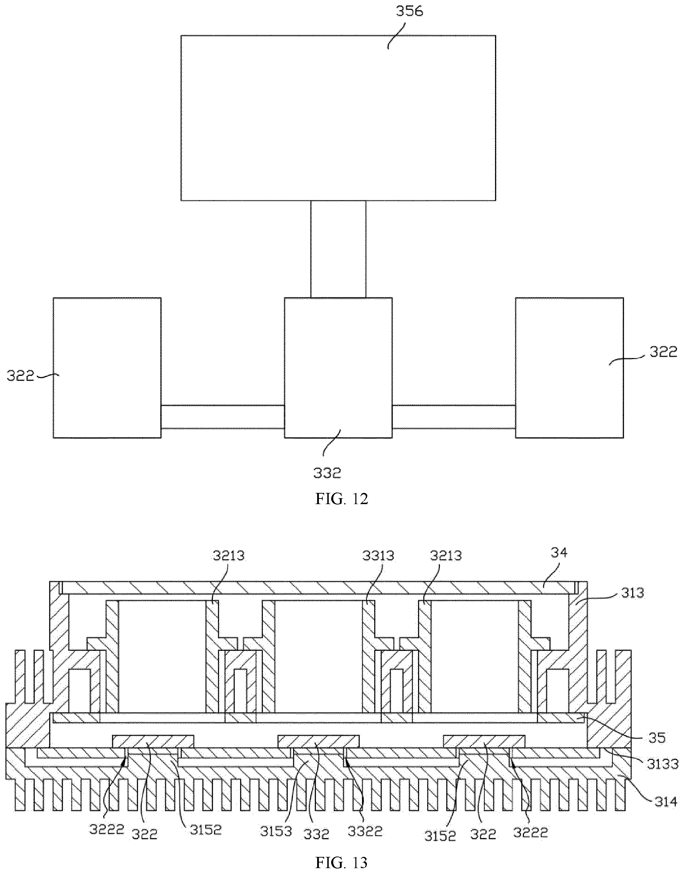

A receiving sensor on the receiving board 332 can be integrated with the main control chip, so that the total thermal power of the LiDAR 3 is reduced and the volume of the LiDAR 3 is reduced. The receiving sensor can be integrated with the main control chip, for example, the receiving chip has the function of the main control chip. The receiving sensor on the receiving board 332 can also not be integrated with the main control chip. Referring to FIG. 12, the LiDAR 3 can also include both the receiving board 332 and the main control board 356. When the LiDAR 3 includes the main control board 356, the functional board 35 can include the main control board 356. For example, the main control board 356 can be located on one side of the emitting board 322 away from the light transmitting plate 34 and on one side of the receiving board 332 away from the light transmitting plate 34. The main control board 356 can be in contact with the first housing 313, so that heat dissipation can be performed through the first housing 313. Of course, the main control board 356 can also be located on one side of the emitting board 322 away from the light transmitting plate 34 and on one side of the receiving board 332 away from the light transmitting plate 34. The main control board 356 can be in contact with the second housing 314, so that heat dissipation can be performed through the second housing 314.

The LiDAR 3 includes multiple rigid circuit boards, for example, the emitting board 322, the receiving board 332, the functional board 35, the transferring board 39, and the like. These rigid circuit boards can be fixedly connected to the housing 31 to avoid a problem that the rigid circuit board moves relative to the housing 31 during movement of the LiDAR 3.

The fixed connection between the rigid circuit board and the housing 31 can be a screw connection, a snap-fit connection, and the like.

Referring to FIG. 6 to FIG. 8. The housing 31 is provided with a first fixing column 318. The emitting board 322 is provided with a first mounting hole 3221 corresponding to the first fixing column 318. The emitting board 322 is mounted on the first fixing column 318 of the housing 31 through the first mounting hole 3221. The first fixing column 318 and the first mounting hole 3221 can be an interference fit or a clearance fit. If the first fixing column 318 and the first mounting hole 3221 are a clearance fit, the first fixing column 318 and the first mounting hole 3221 can also have a first adhesive layer 3181 to fix the relative position between the emitting board 322 and the housing 31, and then fix the relative position between the emitting board 322 and the emitting lens 321.

The first adhesive layer 3181 can be a UV hot-curing composite adhesive layer. After the first fixing column 318 and the first mounting hole 3221 are assembled, the UV light is irradiated to pre-fix, and then the heat is solidified to enhance the strength. The first adhesive layer 3181 can also use more than two layers of adhesive layers. After the first fixing column 318 and the first mounting hole 3221 are assembled, the UV glue is irradiated with UV light to fix, and then another glue is heat-cured to enhance the fixation.

The housing 31 can be provided with a first fixing column 318, or can be provided with a plurality of first fixing columns 318, for example, three, four, five first fixing columns 318, and so on. In some embodiments, the housing 31 can be provided with four first fixing columns 318. The emitting board 322 is provided with a first mounting hole 3221 equal to the number of the first fixing columns 318. The four first mounting holes 3221 can be distributed approximately uniformly around the periphery of the emitting board 322 to improve the connection stability between the emitting board 322 and the housing 31.

The housing 31 can be provided with the first fixing column 318, which can be the first housing 313 provided with the first fixing column 318, so that the emitting lens 321 and the emitting board 322 are mounted and fixed with the first housing 313. The emitting board 322 is mounted and fixed with the first fixing column 318 and the first housing 313, which is also conducive to the heat generated by the emitting board 322 being guided to the first housing 313 through the first fixing column 318. That is, the emitting board 322 can conduct heat to the second housing 314 by contacting the second housing 314, and the emitting board 322 can also conduct heat to the first housing 313 through the first fixing column 318, so that the heat generated by the emitting board 322 is more uniformly distributed, which is conducive to improving the heat dissipation efficiency of the LiDAR 3.

The first fixing column 318 may have a cross-section that is circular, polygonal, or the like, and a shape of the first mounting hole 3221 may be adapted to a shape of the first fixing column 318.

The functional board 35 may be provided with the avoidance region for avoiding the first fixing column 318.

The housing 31 may be provided with a second fixing column 319, and the receiving board 332 may be provided with a second mounting hole 3321 corresponding to the second fixing column 319. The receiving board 332 may be mounted on the second fixing column 319 of the housing 31 via the second mounting hole 3321. The second fixing column 319 and the second mounting hole 3321 may be an interference fit or a clearance fit. If the second fixing column 319 and the second mounting hole 3321 are in clearance fit, the second fixing column 319 and the second mounting hole 3321 may further have a second adhesive layer 3191 to fix a relative position between the receiving board 332 and the housing 31, and further fix a relative position between the receiving board 332 and the receiving lens 331.

The second adhesive layer 3191 can use a UV hot curing composite glue layer. After the assembly of the second fixing column 319 and the second mounting hole 3321, the UV light is irradiated for pre-drying, and then heat curing is performed to enhance the strength. The second adhesive layer 3191 can also use two or more glue layers. After the assembly of the second fixing column 319 and the second mounting hole 3321, the UV glue is irradiated by the UV, and then another glue is heat cured to enhance the fixation.

The housing 31 can be provided with a second fixing column 319, or the housing 31 can be provided with a plurality of second fixing columns 319. For example, three, four, five second fixing columns 319 and so on can be provided. In some embodiments, the housing 31 can be provided with four second fixing columns 319. The receiving board 332 is provided with the second mounting holes 3321 in a number equal to the number of the second fixing columns 319. The four second mounting holes 3321 can be evenly distributed in the periphery of the receiving board 332 to improve the connection stability between the receiving board 332 and the housing 31.

The housing 31 can be provided with the second fixing column 319, which can be that the first housing 313 is provided with the second fixing column 319, so that the receiving lens 331 and the receiving board 332 are mounted and fixed to the first housing 313. The receiving board 332 is mounted and fixed to the first housing 313 via the second fixing column 319, which is conducive to guiding the heat generated by the receiving board 332 to the first housing 313 via the second fixing column 319. That is, the receiving board 332 can transfer heat to the second housing 314 by contacting the second housing 314, and the receiving board 332 can also transfer heat to the first housing 313 via the second fixing column 319, so that the heat generated by the receiving board 332 is more uniformly distributed, which is conducive to improving the heat dissipation efficiency of the LiDAR 3.

The cross section of the second fixing column 319 can be circular, polygonal, and the like, and the shape of the second mounting hole 3321 can be adapted to the shape of the second fixing column 319.

If a partial projection of the emitting board 322 onto the light transmitting plate 34 overlaps with a partial projection of the receiving board 332 onto the light transmitting plate 34, the partial first fixing column 318 and the partial second fixing column 319 can be the same fixing column, to save the internal space of the LiDAR 3.

The multiple first fixing columns 318 included in the LiDAR 3 can be symmetrical about a first line, the multiple second fixing columns 319 included in the LiDAR 3 can be symmetrical about the first line, and the housing 31 can be symmetrical about the first line. Referring to FIG. 5, the periphery of the housing 31 at the first opening 312 can protrude outwards, and can be vertically convex. The housing 31 can be provided with a reinforcing rib at a position of the first fixing column 318 and/or the second fixing column 319, to provide sufficient support strength, prevent the housing 31 from deforming, and prevent the first fixing column 318 and/or the second fixing column 319 from deforming.

The functional board 35 is provided with the avoidance region for avoiding the second fixing column 319.

The functional board 35, the adapter board 39 and the housing 31 can be connected via screws. The functional board 35 can be connected to the first housing 313 via screws, and the adapter board 39 can be connected to the second housing 314 via screws. The LiDAR 3 can include a connector, the connector can be welded to the adapter board 39, and the connector can be connected to the housing via screws.

For facilitating the signal interaction between the LiDAR 3 and the outside, the emitting board 322, the receiving board 332, the functional board 35 and other rigid circuit boards can be electrically connected, so that the signals of the LiDAR 3 can be summarized and interact with the outside signals via an electrical interface. The electrical connection between rigid circuit boards can be implemented by a flexible circuit board 36, an electrical plug and an electrical socket.

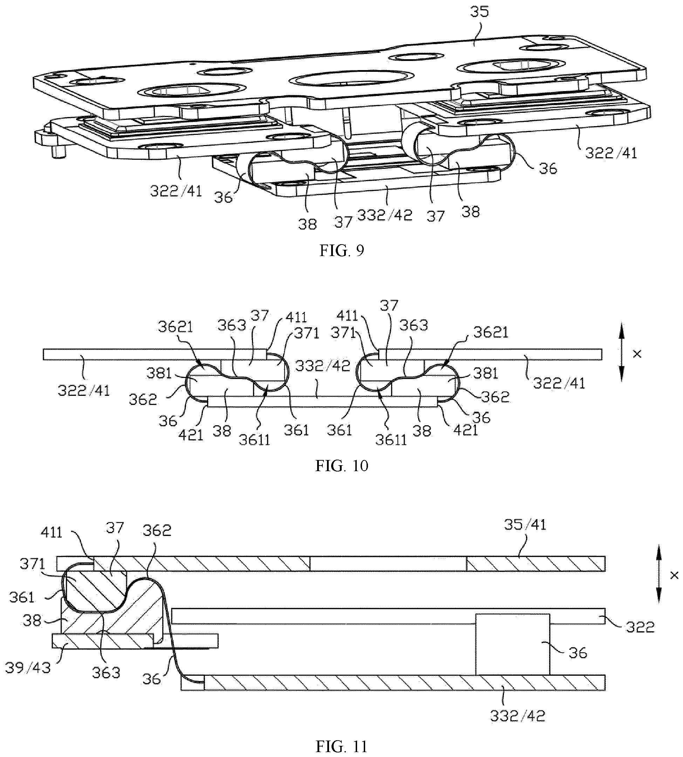

If the two rigid circuit boards are electrically connected via the flexible circuit board 36, the two rigid circuit boards can be defined as a first rigid circuit board 41 and a second rigid circuit board 42 respectively. Referring to FIG. 9 to FIG. 11, the flexible circuit board 36 includes a first bent portion 361 and a second bent portion 362, the first bent portion 361 and the second bent portion 362 are provided along an extending direction of the flexible circuit board 36, and the first bent portion 361 and the second bent portion 362 are bent in opposite directions. During the assembly of the first rigid circuit board 41, the second rigid circuit board 42 and the housing 31, the reciprocating first bent portion 361 and the second bent portion 362 can provide a certain amount of space for the assembly of the first rigid circuit board 41, the second rigid circuit board 42 and the housing 31, which is more convenient to assemble.

The first bent portion 361 defines a first interval 3611, the second bent portion 362 defines a second interval 3621. The LiDAR 3 can further include a first positioning member 37 and a second positioning member 38 that are connected to the housing 31. The first positioning member 37 is located in the first interval 3611 and in contact with the first bent portion 361 to position the first bent portion 361. The second positioning member 38 is located in the second interval 3621 and in contact with the second bent portion 362 to position the second bent portion 362. The first positioning member 37 and the second positioning member 38 are arranged to facilitate controllable bending and fixing of the flexible circuit board 36, to ensure a stacking arrangement of the first rigid circuit board 41 and the second rigid circuit board 42, and to avoid excessive vibration of the flexible circuit board, thereby improving the mounting stability of the flexible circuit board 36 in the LiDAR 3 and the connection stability between the flexible circuit board 36 and the first rigid circuit board 41 and the second rigid circuit board 42.

The first positioning member 37 and/or the second positioning member 38 can be elastic, so that the first positioning member 37 and the second positioning member 38 can deform, thereby improving the mounting stability of the flexible circuit board 36. The first positioning member 37 and/or the second positioning member 38 can be made of materials such as silica gel and sponge silica gel.

The first positioning member 37 is in contact with the first bent portion 361, which means that the first positioning member 37 is connected to the first bent portion 361, for example, the first positioning member 37 is connected to the first bent portion 361 by an adhesive. The first positioning member 37 is in contact with the first bent portion 361, which means that the first bent portion 361 is placed on the first positioning member 37, and they are not connected. The first positioning member 37 can be in partial contact with the first bent portion 361, so that a part of the first bent portion 361 that is not in contact with the first positioning member 37 can deform, to release stress generated when the first rigid circuit board 41 or the second rigid circuit board 42 vibrates.

The second positioning member 38 is in contact with the second bent portion 362, which can be a connection of the second positioning member 38 and the second bent portion 362, for example, both of them are connected by an adhesive. The second positioning member 38 is in contact with the second bent portion 362, which means that the second bent portion 362 is laid on the second positioning member 38 without a connection. The second positioning member 38 can be partially in contact with the second bent portion 362, so that the part of the second bent portion 362 that is not in contact with the second positioning member 38 can be deformed to release stress generated when the first rigid circuit board 41 or the second rigid circuit board 42 vibrates.

The flexible circuit board 36 includes a first structural part 363, and the first positioning member 37 and the second positioning member 38 are also respectively in contact with two opposite sides of the first structural part 363. With the common abutment of the first positioning member 37 and the second positioning member 38, the position of the first structural part 363 in the housing 31 is fixed. Compared with the setting that the first positioning member 37 and a part of the flexible circuit board 36 in contact with the first positioning member 37 and the second positioning member 38 and a part of the flexible circuit board 36 in contact with the second positioning member 38 are staggered, it is more beneficial to the controllable bending and fixing of the flexible circuit board 36.

The first structural part 363 can satisfy at least two of the following situations: 1. Referring to FIG. 10, along the extending direction of the flexible circuit board 36, the first structural part 363 is located between the first bent portion 361 and the second bent portion 362, the first structural part 363 is independent of the first bent portion 361 and the second bent portion 362; 2. Referring to FIG. 11, the first structural part 363 can be at least a part of the first bent portion 361; 3. The first structural part 363 can be at least a part of the second bent portion 362.

The first positioning member 37 can be located along the first direction x between the first rigid circuit board 41 and the second rigid circuit board 42, and the second positioning member 38 can be located along the first direction x between the first rigid circuit board 41 and the second rigid circuit board 42, where the first rigid circuit board 41 and the second rigid circuit board 42 are arranged at intervals along the first direction x. With the reasonable layout of the first positioning member 37, the second positioning member 38, the first rigid circuit board 41, and the second rigid circuit board 42, a size of the LiDAR 3 in the first direction x can be reduced.

The positioning surface of the first positioning member 37 configured to contact the first bent portion 361 may be a curved surface, a plane, a combination of the curved surface and the plane, and the like. The positioning surface of the second positioning member 38 configured to contact the second bent portion 362 may be a curved surface, a plane, a combination of the curved surface and the plane, and the like.

The first positioning member 37 is connected to the housing 31. For example, the first positioning member 37 is connected to any device mounted in the housing 31, to realize the connection between the first positioning member 37 and the housing 31. The second positioning member 38 is connected to the housing 31, which may be directly connected to the housing 31, or indirectly connected to the housing 31. For example, the second positioning member 38 is connected to any device mounted in the housing 31, to realize the connection between the second positioning member 38 and the housing 31.

The connection between the first positioning member 37 and the housing 31 or the connection between the first positioning member 37 and the device mounted in the housing 31 can be an adhesive connection. The connection between the second positioning member 38 and the housing 31 or the connection between the second positioning member 38 and the device mounted in the housing 31 can be an adhesive connection.

If the first positioning member 37 is connected to the device mounted in the housing 31, and the second positioning member 38 is connected to the device mounted in the housing 31, in an embodiment, referring to FIG. 10, the first positioning member 37 can be connected to a first rigid circuit board 41 mounted in the housing 31, and the second positioning member 38 can be connected to a second rigid circuit board 42 mounted in the housing 31. After the first rigid circuit board 41 and the second rigid circuit board 42 are fixed in the housing 31, positions of first positioning member 37 and second positioning member 38 in the housing 31 is fixed, which is more convenient for assembly.

In an embodiment, the first rigid circuit board 41 may be one of the emitting board 322 and the receiving board 332, and the second rigid circuit board 42 may be the other one of the emitting board 322 and the receiving board 332.

In an embodiment, the first positioning member 37 may be fixed to the first rigid circuit board 41 first, the second positioning member 38 may be fixed to the second rigid circuit board 42, and the first rigid circuit board 41 and the second rigid circuit board 42 may be shaped into a stacked shape in the housing 31, and the flexible circuit board 36 may be bent, to achieve controllable bending and fixing of the flexible circuit board 36.

In an embodiment, the first positioning member 37 may be silicone foam, and the second positioning member 38 may be silicone foam.

In an embodiment, the first rigid circuit board 41 may be one of the receiving board 332 and the functional board 35, and the second rigid circuit board 42 may also be other one of the receiving board 332 and the functional board 35, and so on.

If the first positioning member 37 is connected to the device mounted in the housing 31, and the second positioning member 38 is connected to the device mounted in the housing 31. In an embodiment, referring to FIG. 11, the first positioning member 37 may be connected to the first rigid circuit board 41 or the second rigid circuit board 42 mounted in the housing 31, and the second positioning member 38 may be connected to another device in the housing 31 other than the first rigid circuit board 41 and the second rigid circuit board 42, for example, connected to the third rigid circuit board 43 mounted in the housing 31.

In an embodiment, the first rigid circuit board 41 may be one of the receiving board 332 and the functional board 35, and the second rigid circuit board 42 may be the other one of the receiving board 332 and the functional board 35, and the third rigid circuit board 43 may be the adapter board 39, where, about the adapter board 39.

In an embodiment, the first positioning member 37 may be a silicone foam, and the second positioning member 38 may be a silicone gel with a hardness of about shore A 30, to accurately control the bending shape of the FPC.

If the first positioning member 37 is connected to the device mounted in the housing 31, and/or the second positioning member 38 is connected to the device mounted in the housing 31, and the first positioning member 37 and the second positioning member 38 are connected relative two sides of the first structural part 363, the first positioning member 37 and/or the second positioning member 38 can be in a compressed state. The device connected to the first positioning member 37 in the housing 31 (for example, the first rigid circuit board 41) and the device connected to the second positioning member 38 in the housing 31 (for example, the second rigid circuit board 42) can compress the first positioning member 37 and the second positioning member 38, thereby improving the stability of fixing the first positioning member 37 and the second positioning member 38 to the flexible circuit board 36.

The first rigid circuit board 41 has a first side wall 411. The flexible circuit board 36 can be connected to the first side wall 411 of the first rigid circuit board 41. The first positioning member 37 can include a first positioning part 371. The first positioning part 371 is located on one side of the first side wall 411 of the first rigid circuit board 41. The flexible circuit board 36 bypasses the first positioning part 371 on the side away from the first side wall 411, to avoid the risk of the flexible circuit board 36 being broken at the connection with the first rigid circuit board 41 due to excessive bending of the flexible circuit board 36.

The second rigid circuit board 42 has a second side wall 421. The flexible circuit board 36 can be connected to the second side wall 421 of the second rigid circuit board 42. The second positioning member 38 can include a second positioning part 381. The second positioning part 381 is located on one side of the second side wall 421 of the second rigid circuit board 42. The flexible circuit board 36 bypasses the second positioning part 381 on the side away from the second side wall 421 to avoid breaking the part of the flexible circuit board 36 connected to the second rigid circuit board 42 due to excessive bending of the flexible circuit board 36.

The bending angle of the first bending portion 361 can be greater than or equal to 160°, and the bending angle of the second bending portion 362 can be greater than or equal to 160°, so that the first bending portion 361 and the second bending portion 362 can have sufficient deformation to facilitate assembly of the first rigid circuit board 41 and the second rigid circuit board 42 with the housing 31.

In some embodiments, the flexible circuit board 36 and the first rigid circuit board 41 and/or the second rigid circuit board 42 form an integral molded structure. For example, a multilayer structure of the first rigid circuit board 41 and/or the second rigid circuit board 42 includes a flexible substrate layer, and the flexible substrate layer shares the same flexible substrate with the flexible circuit board 36. In terms of the interface between the flexible circuit board 36 and the first rigid circuit board 41 and/or the second rigid circuit board 42, the volume required for the interface can be saved, and operating costs can be reduced.

In the embodiments of the present application, the emitting board 322 and the receiving board 332 are electrically connected by the flexible circuit board 36, and the emitting board 322, the receiving board 332, and the flexible circuit board 36 are integrally formed; the receiving board 332 and the functional board 35 are electrically connected by another flexible circuit board 36, and the receiving board 332, the functional board 35, and the flexible circuit board 36 are integrally formed, to achieve high integration of the entire device and simple overall material control, which is beneficial for production, assembly, and cost reduction.

The electrical connection between the flexible circuit board 36 and the first rigid circuit board 41 and/or the second rigid circuit board 42 can also be implemented by an interface.

The LiDAR 3 in embodiments can include one emitting component 32 and one receiving component 33, or can include one emitting component 32 and multiple receiving components 33, or can include multiple emitting components 32 and multiple receiving components 33, or can include multiple emitting components 32 and one receiving component 33, and so on.

When assembling the LiDAR 3 in embodiments, the light transmitting plate 34, the first housing 313, the emitting component 32, the receiving component 33, the functional board 35, etc. can be first assembled to form a first assembly, the second housing 314, the waterproof and breathable valve, the connector, the adapter board 39, etc. can be assembled to form a second assembly, and then the first assembly and the second assembly are assembled. The assembly is very convenient and reduces material management costs; when the functional board 35 is the power board 355, the first assembly can include all the optomechanics and power supplies, which can already be tested and inspected to a certain extent, which is beneficial for production. The first housing 313 and the second housing 314 in the LiDAR 3 can be formed by die casting and machining, which greatly reduces production costs and material management costs.

When the LiDAR 3 is mounted on a vehicle or another object, the LiDAR 3 can be mounted to the object through a mounting component. The mounting component can include a mounting bracket 45 and a fastener such as a screw. The mounting bracket 45 can be formed on the LiDAR 3 or the object. If the mounting bracket 45 is formed on the LiDAR 3, and referring to FIG. 5 and FIG. 6, the mounting bracket 45 can be formed on the housing 31 of the LiDAR 3. Further, there can be at least two mounting brackets 45, and the at least two mounting brackets 45 can be respectively disposed on two opposite sides of the housing 31 to reliably mount the LiDAR 3 to the object. Further, the mounting bracket 45 can be formed on the second housing 314 and/or the first housing 313 of the housing 31.

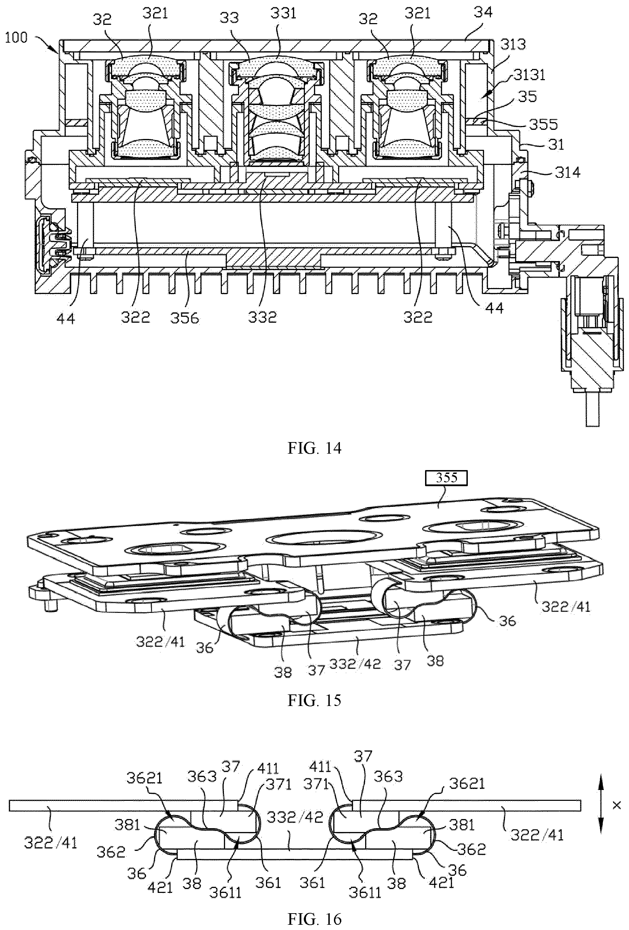

Referring to FIG. 13 and FIG. 14, embodiments provide LiDAR 3. In an embodiment, the emitting board 322 and the receiving board 332 share the same substrate, as long as the emitting board 322 can emit the detection light to the emitting lens 321, and the receiving board 332 can receive the echo light output by the receiving lens 331.

Referring to FIG. 13, in an embodiment, the receiving sensor on the receiving board 332 can be integrated with the main control chip, the main control board can be omitted, so that the total thermal power of the LiDAR 3 is reduced, and the volume of the LiDAR 3 is reduced. The emitting board 322 and the receiving board 332 can be in contact with the second housing 314 of the housing 31 for heat dissipation. For example, the substrate shared by the emitting board 322 and the receiving board 332 can be provided with a first heat dissipation hole 3222 at a setting portion of the emitting sensor. The second housing 314 can be provided with a second convex platform 3152 at the setting portion of the emitting sensor. The second convex platform 3152 can be in contact with the emitting sensor through the first heat dissipation hole 3222, so that heat generated by the emitting sensor is transferred to the second housing 314. The substrate shared by the emitting board 322 and the receiving board 332 can be provided with a second heat dissipation hole 3322 at a setting portion of the receiving sensor. The second housing 314 can be provided with a third convex platform 3153 at the setting portion of the receiving sensor. The third convex platform 3153 can be in contact with the receiving sensor through the second heat dissipation hole 3322, so that heat generated by the receiving sensor is transferred to the second housing 314.

Referring to FIG. 13, the emitting board 322 and the receiving board 332 can be in contact with the first housing 313 of the housing 31 for heat dissipation. For example, as shown in FIG. 13, the emitting board 322 and the receiving board 332 are in contact with the first surface 3133 of the second housing 314 for heat dissipation.

Referring to FIG. 14, the receiving sensor on the receiving board 332 and the main control chip can be separately provided. In an embodiment, the LiDAR 3 includes a main control board 356. The functional board 35 can include the main control board 356 and/or the power board 355. When the functional board 35 includes the main control board 356, the main control board 356 is located on one side of the emitting board 322 away from the light transmitting plate 34 and on one side of the receiving board 332 away from the light transmitting plate 34. The main control board 356 can be in contact with the first housing 313, for heat dissipation via the first housing 313.

FIG. 14 shows a situation that the functional board 35 includes the power board 355, the power board 355 is disposed on one side of the emitting board 322 that is close to the light transmitting plate 34 and on one side of the receiving board 332 that is close to the light transmitting plate 34, and the main control board 356 is disposed on one side of the emitting board 322 that is away from the light transmitting plate 34 and on one side of the receiving board 332 that is away from the light transmitting plate 34. The main control board 356 can be in contact with the second housing 314 to dissipate heat through the second housing 314, while the emitting board 322 and the receiving board 332 can be connected to the housing 31 through the bracket 44 or the like to assemble the emitting board 322 and the receiving board 332 in the housing 31, and facilitate the emitting board 322 and the receiving board 332 to transfer heat to the housing 31 through the bracket 44. The emitting board 322 and the receiving board 332 can also be connected to the main control board 356 through the bracket 44, to connect the emitting board 322 and the receiving board 332 to the housing 31.

Referring to FIG. 3 to FIG. 6, the LiDAR 3 includes a housing 31 and multiple sets of mounting components, and each mounting component includes a first rigid circuit board 41, a second rigid circuit board 42, a flexible circuit board 36, a first positioning member 37, and a second positioning member 38.

The first rigid circuit board 41 is connected to the housing 31, the second rigid circuit board 42 is connected to the housing 31, the second rigid circuit board 42 is spaced apart from the first rigid circuit board 41 in a first direction x, a portion of a projection of the second rigid circuit board 42 on a first plane overlaps with a portion of a projection of the first rigid circuit board 41 on the first plane, the first direction x is perpendicular to a surface of the first rigid circuit board 41, the first plane is parallel to the surface of the first rigid circuit board 41, to compress the first rigid circuit board 41 and the second rigid circuit board 42 in a direction parallel to the first plane, to reduce the volume of the LiDAR 3.

The flexible circuit board 36 is connected to the first rigid circuit board 41 and the second rigid circuit board 42 and is electrically connected to the first rigid circuit board 41 and the second rigid circuit board 42. The flexible circuit board 36 includes a first bent portion 361 and a second bent portion 362. The first bent portion 361 and the second bent portion 362 are provided along an extending direction of the flexible circuit board 36. The first bent portion 361 and the second bent portion 362 are bent in opposite directions. In the assembly of the first rigid circuit board 41, the second rigid circuit board 42, and the housing 31, the round-trip bent first bent portion 361 and the second bent portion 362 can provide a certain amount of space for the assembly of the first rigid circuit board 41, the second rigid circuit board 42, and the housing 31, which is more convenient to assemble.

The extending direction of the flexible circuit board 36 can be as follows: the flexible circuit board 36 is connected from one end of the first rigid circuit board 41 to one end of the second rigid circuit board 42, or the flexible circuit board 36 is connected from one end of the second rigid circuit board 42 to one end of the first rigid circuit board 41. The flexible circuit board 36 is generally a sheet-like structure. The flexible circuit board 36 has a first surface and a second surface that opposite each other. The first bent portion 361 and the second bent portion 362 are bent in opposite directions, which can be as follows: the first bent portion 361 bulges from the first surface to the second surface, and the second bent portion 362 bulges from the second surface to the first surface. The first interval 3611 defined by the first bent portion 361 can be on one side of the first surface, and the second interval 3621 defined by the second bent portion 362 can be on one side of the second surface.

Further, the first positioning member 37 is located in the first interval 3611 and in contact with the first bent portion 361 to position the first bent portion 361; and the second positioning member 38 is located in the second interval 3621 and in contact with the second bent portion 362 to position the second bent portion 362. The first positioning member 37 and the second positioning member 38 are arranged to facilitate controllable bending and fixing of the flexible circuit board 36, ensure a stacking form of the first rigid circuit board 41 and the second rigid circuit board 42, and avoid excessive excitation of the flexible circuit board 36 due to vibration, thereby improving mounting stability of the flexible circuit board 36 in the LiDAR 3 and improving connection stability between the flexible circuit board 36 and the first rigid circuit board 41 and the second rigid circuit board 42.

The first positioning member 37 and/or the second positioning member 38 can be elastic, so that the first positioning member 37 and the second positioning member 38 can deform, thereby improving mounting stability of the flexible circuit board 36. The first positioning member 37 and the second positioning member 38 can be made of materials such as silica gel and silicone foam.

The first positioning member 37 is connected to the first bent portion 361, which can be as follows: the first positioning member 37 is connected to the first bent portion 361, for example, the two are connected by an adhesive. The first positioning member 37 is in contact with the first bent portion 361, which can be as follows: the first bent portion 361 is laid on the first positioning member 37, and the two are not connected. The first positioning member 37 can be in partial contact with the first bent portion 361, so that a part of the first bent portion 361 that is not in contact with the first positioning member 37 can deform to release stress generated when the first rigid circuit board 41 or the second rigid circuit board 42 vibrates.

The second positioning member 38 in contact with the second bent portion 362 can be a connection of the second positioning member 38 and the second bent portion 362, for example, both of them are connected by an adhesive. The second positioning member 38 in contact with the second bent portion 362 can means that the second bent portion 362 is laid on the second positioning member 38 without a connection. The second positioning member 38 can partially contact the second bent portion 362, so that a part of the second bent portion 362 that is not in contact with the second positioning member 38 can deform to release stress generated by jitter of the first rigid circuit board 41 or the second rigid circuit board 42.

The flexible circuit board 36 includes a first structural part 363, and the first positioning member 37 and the second positioning member 38 are also in contact with two opposite sides of the first structural part 363. With the joint abutting of the first positioning member 37 and the second positioning member 38, the position of the first structural part 363 in the housing 31 is fixed, which is more conducive to the controllable bending and fixing of the flexible circuit board 36 compared to the setting that the portion of the flexible circuit board 36 in contact with the first positioning member 37 is staggered with the portion of the flexible circuit board 36 in contact with the second positioning member 38.

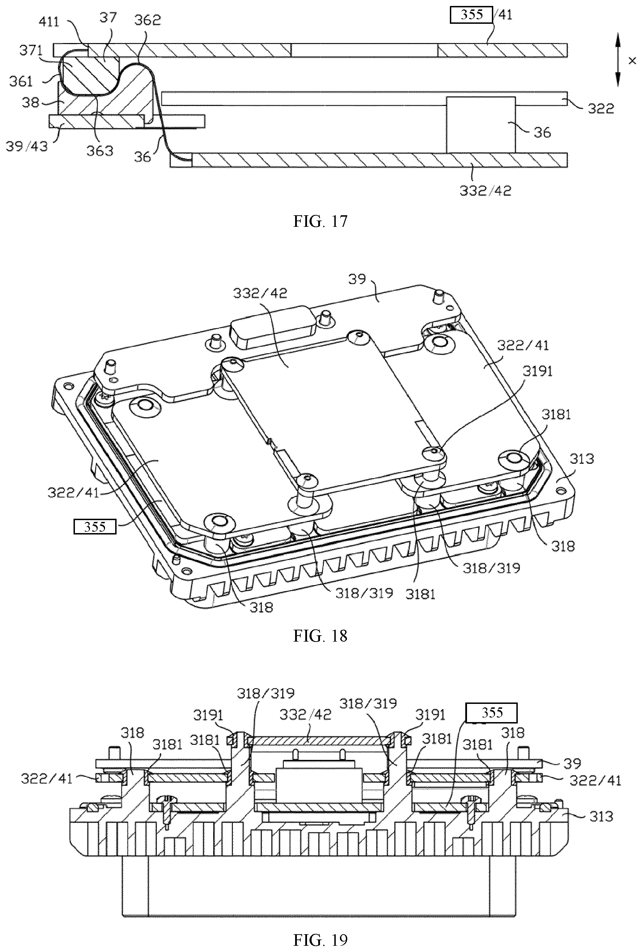

FIG. 16 shows that along the extending direction of the flexible circuit board 36, the first structural part 363 is located between the first bent portion 361 and the second bent portion 362, the first structural part 363 is independent of the first bent portion 361 and the second bent portion 362. FIG. 17 shows that the first structural part 363 can constitute at least a portion of the first bent portion 361, and/or the first structural part 363 can constitute at least a portion of the second bent portion 362.

The first positioning member 37 can be located between the first rigid circuit board 41 and the second rigid circuit board 42 along a first direction x, and the second positioning member 38 can be located between the first rigid circuit board 41 and the second rigid circuit board 42 along the first direction x, where the first rigid circuit board 41 and the second rigid circuit board 42 are arranged at intervals along the first direction x. By reasonably arranging the first positioning member 37, the second positioning member 38, the first rigid circuit board 41, and the second rigid circuit board 42, a size of the LiDAR 3 in the first direction x can be reduced.

The first positioning member 37 may have a positioning surface for contacting the first bent portion 361, and the positioning surface may be a curved surface, a plane, a combination of a curved surface and a plane, and the like. The second positioning member 38 may have a positioning surface for contacting the second bent portion 362, and the positioning surface may be a curved surface, a plane, a combination of a curved surface and a plane, and the like.

To enable the first positioning member 37 to position the first bent portion 361, the first positioning member 37 may be fixed relative to the housing 31. To enable the second positioning member 38 to position the second bent portion 362, the second positioning member 38 may be fixed relative to the housing 31. The first positioning member 37 may be fixed relative to the housing 31, for example, the first positioning member 37 may be connected to and fixed to the housing 31. For example, the first positioning member 37 may be connected and fixed to any device mounted in the housing 31, thereby being connected and fixed to the housing 31. The second positioning member 38 may be fixed relative to the housing 31. For example, the second positioning member 38 may be connected and fixed to any device mounted in the housing 31, thereby being connected and fixed to the housing 31.

The connection between the first positioning member 37 and the housing 31 or the connection between the first positioning member 37 and the device mounted in the housing 31 can be an adhesive connection, and the connection between the second positioning member 38 and the housing 31 or the connection between the second positioning member 38 and the device mounted in the housing 31 can be an adhesive connection.

In an embodiment, when the first positioning member 37 is connected to the device mounted in the housing 31 and the second positioning member 38 is connected to the device mounted in the housing 31, referring to FIG. 6, the first positioning member 37 can be connected to the first rigid circuit board 41 mounted in the housing 31, and the second positioning member 38 can be connected to the second rigid circuit board 42 mounted in the housing 31. After the first rigid circuit board 41 and the second rigid circuit board 42 are positioned in the housing 31, the positions of the first positioning member 37 and the second positioning member 38 in the housing 31 will be fixed, which is more convenient for assembly. The first positioning member 37 can be first fixed to the first rigid circuit board 41, the second positioning member 38 can be fixed to the second rigid circuit board 42, and then the first rigid circuit board 41 and the second rigid circuit board 42 are roughly shaped into a stacked shape in the housing 31, the flexible circuit board 36 is bent and placed in the housing 31 as a whole, to achieve controllable bending and fixing of the flexible circuit board 36.

In an embodiment, the first positioning member 37 can be a silicone foam, and the second positioning member 38 can be a silicone foam.

In an embodiment, the first rigid circuit board 41 can have a first side wall 411. The flexible circuit board 36 can be connected to the first side wall 411 of the first rigid circuit board 41. The first positioning member 37 can include a first positioning part 371. The first positioning part 371 can be located on one side of the first side wall 411 of the first rigid circuit board 41, and the flexible circuit board 36 can bypass the first positioning part 371 on the side away from the first side wall 411 to avoid the first flexible circuit board 36 being excessively bent and broken at the connection with the first rigid circuit board 41.

In an embodiment, the second rigid circuit board 42 can have a second side wall 421. The flexible circuit board 36 can be connected to the second side wall 421 of the second rigid circuit board 42. The second positioning member 38 can include a second positioning part 381. The second positioning part 381 can be located on one side of the second side wall 421 of the second rigid circuit board 42, and the flexible circuit board 36 can bypass the second positioning part 381 on the side away from the second side wall 421, to avoid the flexible circuit board 36 being excessively bent and broken at the connection with the second rigid circuit board 42.

In an embodiment, when the first positioning member 37 is connected to the device mounted in the housing 31, and the second positioning member 38 is connected to the device mounted in the housing 31. Referring to FIG. 17, the first positioning member 37 may be connected to the first rigid circuit board 41 or the second rigid circuit board 42 mounted in the housing 31, and the second positioning member 38 may be connected to another device in the housing 31 other than the first rigid circuit board 41 and the second rigid circuit board 42, for example, the third rigid circuit board 43 mounted in the housing 31. The first positioning member 37 may be silicone foam, and the second positioning member 38 may be silicone with a hardness of about shore A 30, to more accurately control the bending shape of the FPC.

When the first positioning member 37 is connected to the device mounted in the housing 31, and/or the second positioning member 38 is connected to the device mounted in the housing 31, and the first positioning member 37 and the second positioning member 38 are respectively abutted against two opposite sides of the first structural part 363, at this time, the first positioning member 37 and/or the second positioning member 38 may be in a compressed state. The device connected to the first positioning member 37 (for example, the first rigid circuit board 41) in the housing 31 and the device connected to the second positioning member 38 (for example, the second rigid circuit board 42) in the housing 31 may squeeze the first positioning member 37 and the second positioning member 38, which can improve the stability of fixing the first positioning member 37 and the second positioning member 38 to the flexible circuit board 36.

The bending angle of the first bent portion 361 can be greater than or equal to 160 degrees, and the bending angle of the second bent portion 362 can be greater than or equal to 160 degrees, so that the first bent portion 361 and the second bent portion 362 can have sufficient deformation to assemble the first rigid circuit board 41 and the second rigid circuit board 42 with the housing 31.

In some embodiments, the flexible circuit board 36 and the first rigid circuit board 41 and/or the second rigid circuit board 42 have an integral molded structure. For example, a multilayer structure of the first rigid circuit board 41 and/or the second rigid circuit board 42 includes a flexible substrate layer, and the flexible substrate layer shares the same flexible substrate with the flexible circuit board 36. The embodiments can save the volume required for the interface and reduce operating costs. Electrical connection between the flexible circuit board 36 and the first rigid circuit board 41 and/or the second rigid circuit board 42 can also be implemented through the interface.

The fixed connection between the first rigid circuit board 41, the second rigid circuit board 42, and the housing 31 can be a screw connection, a snap-fit connection, and the like.

Reference to FIG. 18 to FIG. 20, the housing 31 is provided with at least one first fixing column 318. The first rigid circuit board 41 is provided with a first mounting hole 3221 corresponding to the first fixing column 318. The first rigid circuit board 41 is mounted on the first fixing column 318 via the first mounting hole 3221. The first fixing column 318 and the first mounting hole 3221 can be an interference fit or a gap fit. When the first fixing column 318 and the first mounting hole 3221 are gap fitted, the first fixing column 318 and the first mounting hole 3221 can also be provided with a first adhesive layer 3181 to fix the relative position between the first rigid circuit board 41 and the housing 31.

The first adhesive layer 3181 can be a UV hot-curing composite adhesive layer. After the first fixing column 318 and the first mounting hole 3221 are assembled, the first adhesive layer 3181 can be pre-cured by UV irradiation first, and then heat-cured to enhance the strength. The first adhesive layer 3181 can also be two or more adhesive layers. After the first fixing column 318 and the first mounting hole 3221 are assembled, the UV adhesive can be fixed by UV irradiation first, and then the other glue can be heat-cured to enhance the fixation.

The housing 31 can be provided with a first fixing column 318, or can be provided with a plurality of first fixing columns 318. For example, two, three, four, five first fixing columns 318, and the like can be provided. In some embodiments, the housing 31 can be provided with four first fixing columns 318. The first rigid circuit board 41 is provided with first mounting holes 3221 equal in number to the first fixing columns 318. The four first mounting holes 3221 can be roughly evenly distributed on the periphery of the first rigid circuit board 41 to improve the connection stability between the first rigid circuit board 41 and the housing 31.

The housing 31 is provided with at least one second fixing column 319. The second rigid circuit board 42 is provided with a second mounting hole 3321 corresponding to the second fixing column 319, and the second rigid circuit board 42 is mounted on the second fixing column 319 via the second mounting hole 3321. The second fixing column 319 and the second mounting hole 3321 can be an interference fit or a gap fit. If the second fixing column 319 and the second mounting hole 3321 are gap fitted, the gap between the second fixing column 319 and the second mounting hole 3321 can also be provided with a second adhesive layer 3191 to fix the relative position between the second rigid circuit board 42 and the housing 31, and then fix the relative position between the second rigid circuit board 42 and the receiving lens 331.

The second adhesive layer 3191 can be UV hot-curing composite adhesive layer, and can be pre-cured by UV irradiation first after the assembly of the second fixing column 319 and the second mounting hole 3321, and then heat-cured to enhance the strength. The second adhesive layer 3191 can also use two or more layers of adhesive layers, and can be fixed by UV irradiation UV glue first after the assembly of the second fixing column 319 and the second mounting hole 3321, and then heat-cured another glue to enhance the fixation.

The housing 31 can be provided with one second fixing column 319, or multiple second fixing columns 319 can be provided, for example, two, three, four, five second fixing columns 319 and so on. In some embodiments, the housing 31 can be provided with four second fixing columns 319. The second rigid circuit board 42 is provided with the same number of second mounting holes 3321 as the second fixing columns 319. The four second mounting holes 3321 can be distributed on the periphery of the second rigid circuit board 42 to improve the connection stability between the second rigid circuit board 42 and the housing 31.

Further, the at least one first fixing column 318 and the at least one second fixing column 319 may be the same fixing column, to save internal space of the LiDAR 3. For example, the first fixing column 318 and the second fixing column 319 may be arranged in a portion where a projection of the first rigid circuit board 41 on the first plane and a projection of the second rigid circuit board 42 on the first plane overlap, and the first fixing column 318 in the portion may share the same fixing column with the second fixing column 319.

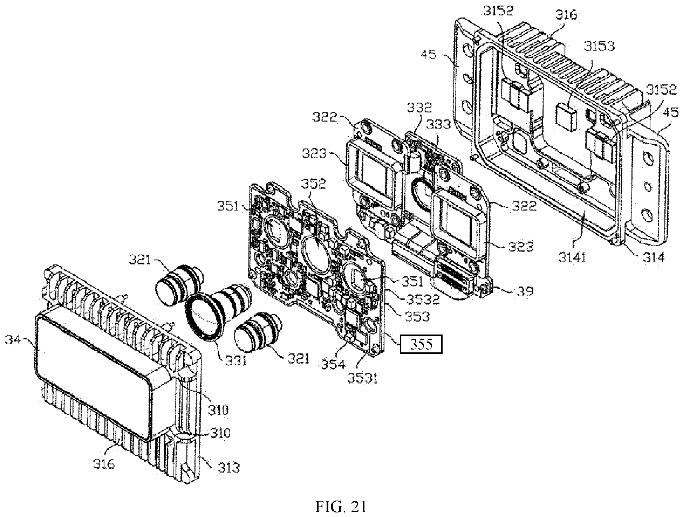

A plurality of the first fixing columns 318 included in the LiDAR 3 may be symmetrical about the first line, a plurality of the second fixing columns 319 included in the LiDAR 3 may be symmetrical about the first line, and the housing 31 may also be symmetrical about the first line. Referring to FIG. 21, the periphery of the housing 31 at the first opening 312 may protrude outward, and may specifically be vertically convex. The housing 31 at the first fixing column 318 and/or the second fixing column 319 may be provided with a reinforcing rib, to provide sufficient support strength, prevent the housing 31 from being deformed, and prevent the first fixing column 318 and/or the second fixing column 319 from being deformed.

Referring to FIG. 3 and FIG. 4, the LiDAR 3 includes an emitting component 32, a receiving component 33, a light transmitting plate 34, and a power board 355. The housing 31 has a receiving cavity 311. The emitting component 32, the receiving component 33, and the power board 355 are located in the receiving cavity 311. The housing 31 is provided with an opening 312 in communication with the receiving cavity 311. The light transmitting plate 34 covers the opening 312. The light transmitting plate 34 is connected to the housing 31. The emitting component 32 includes an emitting lens 321 and an emitting board 322. The emitting board 322 is located on one side of the emitting lens 321 away from the light transmitting plate 34 along a first direction x. The receiving component 33 includes a receiving lens 331 and a receiving board 332. The receiving board 332 is located on one side of the receiving lens 331 away from the light transmitting plate 34 along the first direction x. The functional board 35 is electrically connected to the emitting board 322 and the receiving board 332. The emitting board 322 and the receiving board 332 are located on the same side of the power board 355.

A portion of a projection of the emitting board 322 onto a first plane overlaps with a portion of a projection of the power board 355 onto the first plane. A portion of a projection of the receiving board 332 onto the first plane overlaps with a portion of a projection of the power board 355 onto the first plane, to utilize the internal space of the LiDAR 3 and reduce the volume of the LiDAR 3.

The LiDAR 3 includes a floating connector. The floating connector is mounted on one side of the power board 355 close to the receiving board 332. The floating connector is electrically connected to the power board 355. A projection of the floating connector onto the first plane is outside a projection of the emitting board 322 onto the first plane. A projection of the floating connector onto the first plane is outside a projection of the receiving board 332 onto the first plane, so that the floating connector is arranged to utilize the internal space of the LiDAR 3 and avoid an excessively large volume of the LiDAR 3. The floating connector is arranged to facilitate connection with an external power supply, a signal, and the like.

Referring to FIG. 18 and FIG. 19, the LiDAR 3 includes a connecting board 39. The connecting board 39 is connected to the housing 31. The connecting board 39 is located between the receiving board 332 and the power board 355 in a first direction x. A projection of the connecting board 39 on a first plane is outside a projection of the emitting board 322 on the first plane. A projection of the connecting board 39 on the first plane is outside a projection of the receiving board 332 on the first plane. The connecting board 39 is arranged to make use of the internal space of the LiDAR 3 and avoid an excessively large volume of the LiDAR 3. The connecting board 39 can be connected to the power board 355 via a floating connector. The floating connector includes a male connector and a female connector that are adapted to be used in combination. The male connector can be provided on the power board 355, and the female connector can be provided on the connecting board 39.

The connecting board 39 connected to the housing 31 can be connected to the housing 31 via a screw.

Referring to FIG. 3 and FIG. 4, the power board 355 is located on one side of the emitting board 322 close to the light transmitting plate 34 along the first direction x. The power board 355 is located on one side of the receiving board 332 close to the light transmitting plate 34 along the first direction x. The power board 355 avoids an optical transmission path between the emitting board 322 and the emitting lens 321. The power board 355 also avoids an optical transmission path between the receiving lens 331 and the receiving board 332. The power board 355 is in contact with the housing 31. The power board 355 avoids an optical transmission path between the emitting board 322 and the emitting lens 321, which ensures that the detection light emitted by the emitting board 322 can smoothly reach the emitting lens 321. The power board 355 avoids an optical transmission path between the receiving lens 331 and the receiving board 332, which ensures that the echo light output by the receiving lens 331 can smoothly reach the receiving board 332. The power board 355 is in contact with the housing 31, which is conducive to transferring heat generated by the electronic components 354 of the power board 355 to the housing 31.

Due to the limitation of the entire structure, the optical path between the transceiver sensor and the transceiver lens cannot be blocked, a heat generating element on the circuit board is mostly concentrated on one side of the housing away from the light transmitting plate. In order to shorten a heat dissipation path, the heat generating element often dissipates heat directly on the side of the housing away from the light transmitting plate, which causes a concentration of local heat power density and a greater heat dissipation load on the side of the housing away from the light transmitting plate, and uneven temperature of the entire LiDAR. In embodiments of the present application, the power board 355 is arranged on the side of the emitting board 322 close to the light transmitting plate 34 and the side of the receiving board 332 close to the light transmitting plate 34, which is conducive to the heat generated by the electronic element of the power board 355 being dissipated on the side of the housing close to the light transmitting plate 34, while the heat generated by the emitting board 322 and the receiving board 332 is dissipated on the side of the housing away from the light transmitting plate 34, so that the heat power distribution of the LiDAR 3 is relatively uniform, and the heat dissipation efficiency of the LiDAR 3 is improved.

In an embodiment, a size of the power board 355 can be designed to be compatible with the size of the side of the emitting board 322 close to the light transmitting plate 34 in the housing 31, or the size of the side of the receiving board 332 close to the light transmitting plate 34 in the housing 31, so that the power board 355 can be arranged at the front, and the LiDAR 3 can be maintained on the basis of the original size, or even the power board 355 can be arranged at the front, which can reduce the size of the LiDAR 3 in a direction perpendicular to the light transmitting plate 34, and realize miniaturization of the LiDAR 3.

The power board 355 is provided with a power supply circuit. The power board 355 can be provided with all or part of power supply circuits in the LiDAR 3.

The power board 355 and the emitting board 322 can be spaced apart in a direction perpendicular to the light transmitting plate 34 and/or the first direction x, and the power board 355 and the receiving board 332 can be spaced apart in a direction perpendicular to the light transmitting plate 34 and/or the first direction x, to improve the heat dissipation performance of the LiDAR 3. The spacing between the power board 355 and the emitting board 322 and the spacing between the power board 355 and the receiving board 332 can be adjusted flexibly.

The power board 355 can be located on one side of the emitting board 322 that is close to the light transmitting plate 34, which can mean that the power board 355 is located between the emitting board 322 and the emitting lens 321, or can mean that the power board 355 is located between a first end face 3211 of the emitting lens 321 facing the light transmitting plate 34 and a second end face 3212 of the emitting lens 321 facing the emitting board 322. If the power board 355 is located between the first end face 3211 and the second end face 3212, this can improve the spatial utilization of the peripheral space of the emitting lens 321 in the housing 31 and reduce the volume of the LiDAR 3.

A projection of the power board 355 on the first plane can be on one side of a projection of the emitting lens 321 on the first plane, the power board 355 does not block an optical transmission path between the emitting board 322 and the emitting lens 321. The projection of the power board 355 on the first plane can also surround at least a portion of a projection of the emitting lens 321 on the first plane, the power board 355 is provided with a first avoidance region 351. When the power board 355 is located between the emitting board 322 and the emitting lens 321, the first avoidance region 351 is set to allow the detection light emitted by the emitting board 322 to pass through, so that the detection light smoothly reaches the emitting lens 321. When the power board 355 is located between the first end face 3211 and the second end face 3212, the first avoidance region 351 is set to allow the power board 355 to be assembled with the emitting lens 321 in the housing 31. For example, the first avoidance region 351 can allow the emitting lens 321 to pass through.

The first avoidance region 351 may be a notch at an edge of the power board 355, and the first avoidance region 351 may also be a through-hole on the inner side of the power board 355.

The emitting lens 321 can be in contact with the power board 355 to position the mounting position of the emitting lens 321 via the power board 355. When the power board 355 is located between the emitting board 322 and the emitting lens 321, a side of the emitting lens 321 facing the emitting board 322 can be abutted to the power board 355; or when the power board 355 is located between the first end face 3211 and the second end face 3212 of the emitting lens 321, a periphery of the emitting lens 321 can be provided with a step surface (not shown in the figure), and the step surface of the emitting lens 321 can be abutted to the power board 355.

The emitting lens 321 can include an emitting lens barrel 3213 and at least one emitting lens piece 3214 provided in the emitting lens barrel 3213, and the emitting lens 321 in contact with the power board 355 can be the emitting lens barrel 3213 in contact with the power board 355.

The emitting lens barrel 3213 is used to mount the emitting lens piece 3214. The emitting lens barrel 3213 can be an integrally formed structure with the partial housing 31, to simplify an assembly process of the emitting lens barrel 3213 and the housing 31, improve assembly efficiency, reduce a distance between the emitting lens barrel 3213 and the receiving lens barrel 3313, and reduce the volume of the LiDAR 3. The emitting lens piece 3214 can be any lens with a refractive power. For example, the emitting lens piece 3214 can be a convex lens, a concave lens, and the like. The emitting lens 321 can also include a spacer ring, a locking ring, and the like. The spacer ring is used to support the emitting lens piece 3214 and control a distance between two adjacent emitting lens pieces 3214, and the locking ring is used to fix the emitting lens piece 3214.

The emitting lens barrel 3213 can in contact with the light transmitting plate 34 to improve the mounting stability of the light transmitting plate 34.

The emitting component 32 can further include an emitting shielding cover 323 sleeved on the emitting board 322, and the emitting shielding cover 323 has a first light passing path 3231. When the power board 355 is located between the emitting lens 321 and the emitting board 322, the emitting shielding cover 323 can be connected between the power board 355 and the emitting board 322, and the first light passing path 3231 can communicate with the first avoidance region 351, so that the detection light emitted by the emitting board 322 passes through the first light passing path 3231 and the first avoidance region 351 to enter the emitting lens 321, and is not easily scattered outward, which can reduce light loss. The emitting shielding cover 323 can be connected to the emitting board 322 and the emitting lens 321 via an adhesive, and can abut against the power board 355. The emitting shielding cover 323 can be a light-shielding sponge, so that the emitting shielding cover 323 can be connected to the power board 355 by pressing and deforming to ensure sufficient assembly space. When the power board 355 is located between the first end face 3211 and the second end face 3212, the emitting shielding cover 323 can be connected between the emitting board 322 and the emitting lens 321, and the first light passing path 3231 can communicate with the incident light hole of the emitting lens 321, so that the detection light emitted by the emitting board 322 enters the emitting lens barrel 3213 via the first light passing path 3231. The emitting shielding cover 323 can be connected to the emitting board 322 via welding and a sealing glue can be provided at the connection to prevent light leakage. The emitting shielding cover 323 can be connected to the emitting lens 321 via a sealing glue, to ensure sufficient assembly space.

In some embodiments, the power board 355 is located between the receiving board 332 and the light transmitting plate 34, and the second end surface 3212 of the emitting lens 321 in contact with the power board 355.

The power board 355 is located on a side of the receiving board 332 close to the light transmitting plate 34, and the power board 355 may be located between the receiving board 332 and the receiving lens 331, or the power board 355 may be located between a third end surface 3311 of the receiving lens 331 facing the light transmitting plate 34 and a fourth end surface 3312 of the receiving lens 331 facing the receiving board 332. When the power board 355 is located between the third end surface 3311 and the fourth end surface 3312, the space utilization of the peripheral side of the receiving lens 331 in the housing 31 can be improved, and the volume of the LiDAR 3 can be reduced.

A projection of the power board 355 on the light transmitting plate 34 can be on one side of a projection of the receiving lens 331 on the light transmitting plate 34. The power board 355 does not block an optical transmission path between the receiving board 332 and the receiving lens 331. A projection of the power board 355 on the light transmitting plate 34 can also surround at least a part of a projection of the receiving lens 331 on the light transmitting plate 34. The power board 355 is provided with a second avoidance region 352. When the power board 355 is located between the receiving board 332 and the receiving lens 331, the second avoidance region 352 is set to allow the echo light output by the receiving lens 331 to pass through and reach the receiving board 332. When the power board 355 is located between the third end surface 3311 and the fourth end surface 3312, the second avoidance region 352 is set to facilitate the assembly of the power board 355 and the receiving lens 331 in the housing 31.

Herein, the second avoidance region 352 can be a notch at an edge of the power board 355, and the second avoidance region 352 can also be a through-hole on an inner side of the power board 355.

The receiving lens 331 can in contact with the power board 355 to position the receiving lens 331 through the power board 355. When the power board 355 is located between the receiving board 332 and the receiving lens 331, a side of the receiving lens 331 facing the receiving board 332 can in contact with the power board 355. When the power board 355 is located between the third end surface 3311 and the fourth end surface 3312, a periphery of the receiving lens 331 can be provided with a step surface, and the step surface of the receiving lens 331 can in contact with the power board 355.

The receiving lens 331 can include a receiving lens barrel 3313 and at least one receiving lens piece 3314 provided in the receiving lens barrel 3313, and the receiving lens 331 can in contact with the power board 355, which can be abutting between the receiving lens barrel 3313 and the power board 355.

The receiving lens barrel 3313 can in contact with the light transmitting plate 34 to improve the mounting stability of the light transmitting plate 34.

The receiving component 33 can further include a receiving shielding cover 333 sleeved on the receiving board 332, and the receiving shielding cover 333 has a second light passing path 3331. When the power board 355 is located between the receiving lens 331 and the receiving board 332, the receiving shielding cover 333 can be connected between the power board 355 and the receiving board 332, and the second light passing path 3331 can communicate with the second avoidance region 352, so that the echo light output by the receiving lens 331 reaches the receiving board 332 after passing through the second avoidance region 352 and the second light passing path 3331, to avoid interference between the echo light and other stray light. The receiving shielding cover 333 can be connected between the receiving board 332 and the receiving lens 331 via an adhesive, and can in contact with the connection between the receiving shielding cover 333 and the power board 355. The receiving shielding cover 333 can be a light-shielding sponge, so that the receiving shielding cover 333 can be connected to the power board 355 by pressing and deforming to ensure sufficient assembly space. When the power board 355 is located between the third end face 3311 and the fourth end face 3312, the receiving shielding cover 333 can be connected between the receiving board 332 and the receiving lens 331, and the second light passing path 3331 can communicate with the outgoing light hole of the receiving lens 331, so that the echo light output by the receiving lens 331 reaches the receiving board 332 after passing through the second light passing path 3331; the receiving shielding cover 333 can be connected between the receiving board 332 and the receiving lens 331 via a sealing glue to ensure sufficient assembly space.

In some embodiments, the power board 355 is located between the third end surface 3311 and the fourth end surface 3312, and the receiving lens barrel 3313 of the receiving lens 331 passes through the second avoidance region 352 of the power board 355, the receiving lens barrel 3313 in contact with a step surface of the light transmitting plate 34, and the receiving lens 331 is provided with a step surface facing away from the light transmitting plate 34, and the step surface in contact with the power board 355.

The housing 31 includes a first housing 313 and a second housing 314. The first housing 313 is provided with an opening 312, and the power board 355 is in contact with the first housing 313. The second housing 314 is connected to one side of the first housing 313 away from the opening 312, and the emitting board 322 and the receiving board 332 are both in contact with the second housing 314. The housing 31 is split into the first housing 313 and the second housing 314, which is convenient for the assembly of internal devices such as the emitting component 32, the receiving component 33, and the power board 355. The power board 355 is in contact with the first housing 313, which is convenient for the heat generated by the heating element on the power board 355 to be transferred to the first housing 313. The emitting board 322 and the receiving board 332 are both in contact with the second housing 314, which is convenient for the heat generated by the emitting board 322 and the receiving board 332 to be transferred to the second housing 314, thereby facilitating uniform distribution of the heat power of the LiDAR 3 and improving the heat dissipation efficiency.

The first housing 313 can have a first cavity 3131, and the second housing 314 can have a second cavity 3141 communicated with the first cavity 3131. The emitting board 322 and the receiving board 332 can be both located in the second cavity 3141. The accommodating cavity 311 includes the first cavity 3131 and the second cavity 3141. The power board 355 can be located in the first cavity 3131, or can be located at the junction of the first cavity 3131 and the second cavity 3141, as long as the power board 355 is in contact with the first housing 313. The first housing 313 or the second housing 314 can also be generally plate-shaped, without forming a cavity.

The foregoing mounting of the mounting board 39 to the housing 31 can be mounting the mounting board 39 to the second housing 314. The foregoing mounting of the power board 355 to the housing 31 can be mounting the power board 355 to the first housing 313.

The emitting lens barrel 3213 being integrally formed with a part of the housing 31 can be the emitting lens barrel 3213 being integrally formed with the first housing 313, and the receiving lens 331 being integrally formed with a part of the housing 31 can be the receiving lens barrel 3313 being integrally formed with the first housing 313.

The first housing 313 is provided with a first step 3132, and the power board 355 is located on the first step 3132, to position the power board 355 between the first housing 313. The power board 355 can be in contact with a step wall of the first step 3132, thereby improving the connection stability between the power board 355 and the first housing 313.

In some embodiments, the first housing 313 has a first surface 3133 facing the second housing 314, and the first step 3132 can be formed on the first surface 3133, so that the power board 355 can be mounted on the first step 3132 from the second housing 314 facing one side of the first housing 313. The thickness of the power board 355 in a direction perpendicular to the first surface 3133 can be greater than, less than, or equal to the thickness of the first step 3132 in a direction perpendicular to the first surface 3133.

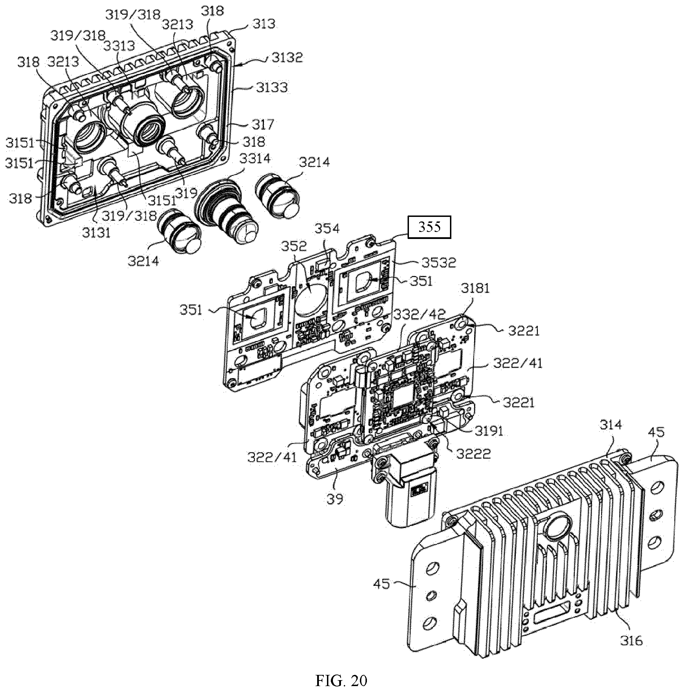

Referring to FIG. 20 and FIG. 21, the power board 355 can include a substrate 353 and electronic components 354. The substrate 353 has a first board surface 3531 facing the light transmitting plate 34 and a second board surface 3532 away from the first board surface 3531. The first board surface 3531 and/or the second board surface 3532 can be mounted with the electronic components 354. The substrate 353 and the electronic components 354 avoid an optical transmission path between the emitting board 322 and the emitting lens 321, and an optical transmission path between the receiving lens 331 and the receiving board 332.

At least some of the electronic components 354 of the power board 355 can be in contact with the thermal conductive gel and the housing 31, so that heat generated by at least some of the electronic components 354 can be transferred to the housing 31 through the thermal conductive gel, which shortens the heat transfer path and helps to enhance heat dissipation. In some embodiments, at least some of the electronic components 354 of the power board 355 can be in contact with the first housing 313 through the thermal conductive gel, which is convenient for the heat generated by the electronic components 354 on the power board 355 to be transferred to the first housing 313. The thermal conductive gel can achieve a high thermal conductivity heat transfer; and the thermal conductive gel has good elasticity and compression deformation after curing, and does not generate great thermal stress, which can avoid a change in position of the power board 355 due to thermal stress deformation.

The housing 31 may be provided with a first convex platform 3151 at the electronic element 354 that needs to conduct heat, and the first convex platform 3151 may be in contact with the electronic element 354 via thermally conductive gel. The thermally conductive gel can be first coated on the electronic element 354 that needs to conduct heat on the power board 355, and then the power board 355 is mounted on the housing 31, so that the thermally conductive gel on the electronic element 354 that needs to conduct heat is in contact with the corresponding first convex platform 3151. The first convex platform 3151 may be provided on the first housing 313. The first convex platform 3151 is convenient for being in contact with the electronic element 354 that needs to conduct heat on the power board 355, without the entire housing 31 being in contact with the power board 355.

In the power board 355, the electronic element 354 in contact with the thermally conductive gel of the housing 31 can be an easily heat-generating electronic element 354, or can be any electronic element 354.

In some embodiments, the receiving sensor receiving the echo light on the receiving board 332 may be integrated with the main control chip, so that the total heat power of the LiDAR 3 is reduced, and the volume of the LiDAR 3 is reduced. The receiving sensor is integrated with the main control chip, for example, the main control chip has a function of receiving the echo light, which can save the main control board, in which the LiDAR includes both the receiving board and the main control board. The receiving sensor receiving the echo light on the receiving board 332 may not be integrated with the main control chip. For example, referring to FIG. 12, the LiDAR 3 may include both the receiving board 332 and the main control board 356. When the LiDAR 3 includes the main control board 356, the main control board 356 may be located on one side of the emitting board 322 away from the light transmitting plate 34 and on one side of the receiving board 332 away from the light transmitting plate 34. The main control board 356 may be in contact with the first housing 313, to be able to conduct heat through the first housing 3 13. The main control board 356 may be located on one side of the emitting board 322 away from the light transmitting plate 34 and on one side of the receiving board 332 away from the light transmitting plate 34. The main control board 356 may be in contact with the second housing 314, to conduct heat through the second housing 314.

When the LiDAR 3 is mounted on a vehicle or another object, the LiDAR 3 can be mounted to the object through a mounting component. The mounting component can include a mounting bracket 45 and a fastener such as a screw. The mounting bracket 45 can be formed on the LiDAR 3 or the object. If the mounting bracket 45 is formed on the LiDAR 3, with reference to FIG. 10 and FIG. 11, the mounting bracket 45 can be formed on the housing 31 of the LiDAR 3. Further, there can be at least two mounting brackets 45, and the at least two mounting brackets 45 can be respectively disposed on two opposite sides of the housing 31 to reliably mount the LiDAR 3 to the object. Further, the mounting bracket 45 can be formed on the second housing 314 and/or the first housing 313 of the housing 31.

The LiDAR 3 can include one emitting component 32 and one receiving component 33, or include one emitting component 32 and multiple receiving components 33, or include multiple emitting components 32 and multiple receiving components 33, or include multiple emitting components 32 and one receiving component 33, and so on.

In some embodiments, referring to FIG. 15 and FIG. 16, one of the first rigid circuit board 41 and the second rigid circuit board 42 may be the emitting board 322, and the other one of the first rigid circuit board 41 and the second rigid circuit board 42 may be the receiving board 332. For example, the first rigid circuit board 41 is the emitting board 322, the second rigid circuit board 42 is the receiving board 332, as the first rigid circuit board 41 and the second rigid circuit board 42 are arranged at intervals in a first direction x, the emitting board 322 and the receiving board 332 are also arranged at intervals in the first direction x.

In some embodiments, the housing 31 is provided with a first fixing column 318, and the first fixing column 318 may be provided in the first housing 313, so that the emitting lens 321, the emitting board 322 and the first housing 313 are mounted and fixed. The emitting board 322 is mounted and fixed to the first housing 313 via the first fixing column 318, which is also beneficial to guiding the heat generated by the emitting board 322 to the first housing 313 via the first fixing column 318. That is, the emitting board 322 can directly transfer heat to the second housing 314 by contacting the second housing 314, and the emitting board 322 can also transfer heat to the first housing 313 via the first fixing column 318, so that the heat generated by the emitting board 322 is more uniformly distributed, which is beneficial to improving the heat dissipation efficiency of the LiDAR 3.

In some embodiments, the power board 355 is provided with an avoidance region for avoiding the first fixing column 318.

In an embodiment, the second fixing column 319 may be provided for the first housing 313, so that a receiving lens 331, a receiving board 332, and the first housing 313 are mounted and fixed. The receiving board 332 is mounted and fixed to the first housing 313 via the second fixing column 319, which is beneficial for guiding heat generated by the receiving board 332 to the first housing 313 via the second fixing column 319. That is, the receiving board 332 can transfer heat to the second housing 314 by contacting the second housing 314, and the receiving board 332 can also transfer heat to the first housing 313 via the second fixing column 319, so that heat generated by the receiving board 332 is more uniformly distributed, thereby improving heat dissipation efficiency of the LiDAR 3.

In an embodiment, the power board 355 is provided with an avoidance region for avoiding the second fixing column 319.

In an embodiment, the first positioning member 37 is connected to the emitting board 322, and the second positioning member 38 is connected to the receiving board 332.

FIG. 17 shows that one of the first rigid circuit board 41 and the second rigid circuit board 42 may be a receiving board 332, and the other one of the first rigid circuit board 41 and the second rigid circuit board 42 may be a power board 355. For example, the first rigid circuit board 41 is the power board 355, the second rigid circuit board 42 is the receiving board 332. Because the first rigid circuit board 41 and the second rigid circuit board 42 are arranged at intervals in a first direction x, the receiving board 332 and the power board 355 are arranged at intervals in the first direction x.

In an embodiment, the emitting board 322 and the receiving board 332 may be arranged at intervals in the first direction x. A portion of a projection of the emitting board 322 on the first plane may overlap with a portion of a projection of the receiving board 332 on the first plane, to reduce a size of the emitting board 322 and the receiving board 332 in a direction parallel to the first plane, and make full use of the internal space of the LiDAR 3 to reduce the volume of the LiDAR 3.

In an embodiment, the emitting board 322 and the receiving board 332 can also share the same substrate. As shown in FIG. 13, the emitting board 322 and the receiving board 332 can be in contact with the second housing 314 of the housing 31 for heat dissipation. For example, the substrate shared by the emitting board 322 and the receiving board 332 can be provided with a first heat dissipation hole 3222 at the setting portion of the emission sensor. The second housing 314 can be provided with a second convex platform 3152 at the emission sensor. The second convex platform 3152 can be in contact with the emission sensor through the first heat dissipation hole 3222, so that heat generated by the emission sensor can be transferred to the second housing 314. The substrate shared by the emitting board 322 and the receiving board 332 can be provided with a second heat dissipation hole 3322 at the setting portion of the receiving sensor. The second housing 314 can be provided with a third convex platform 3153 at the receiving sensor. The third convex platform 3153 can be in contact with the receiving sensor through the second heat dissipation hole 3322, so that heat generated by the receiving sensor can be directly transferred to the second housing 314. Referring to FIG. 13, the emitting board 322 and the receiving board 332 can also be in contact with the first housing 313 of the housing 31 for heat dissipation. For example, the emitting board 322 and the receiving board 332 can be in contact with the first surface 3133 of the first housing 313 facing the second housing 314. Referring to FIG. 14, the emitting board 322 and the receiving board 332 can also be connected to the housing 31 through a bracket 44 or the like, to assemble the emitting board 322 and the receiving board 332 in the housing 31, and to facilitate the emitting board 322 and the receiving board 332 to transfer heat to the housing 31 through the bracket 44. If the LiDAR 3 includes a main control board 356, the emitting board 322 and the receiving board 332 can also be connected to the main control board 356 through the bracket 44, to connect the emitting board 322 and the receiving board 332 to the housing 31.

In an embodiment, the first positioning member 37 is connected to the receiving board 332 or the power board 355, and the second positioning member 38 is connected to the connecting board 39. That is, the connecting board 39 is formed as a third rigid circuit board 43.

The LiDAR 3 includes a plurality of mounting components, wherein one mounting component includes a first rigid circuit board 41 and a second rigid circuit board 42, one of the first rigid circuit board 41 and the second rigid circuit board 42 is the emitting board 322, and the other of the first rigid circuit board 41 and the second rigid circuit board 42 is the receiving board 332, as shown in FIG. 5 and FIG. 6; or another mounting component includes the first rigid circuit board 41 and the second rigid circuit board 42, one of the first rigid circuit board 41 and the second rigid circuit board 42 is the receiving board 332, and the other of the first rigid circuit board 41 and the second rigid circuit board 42 is the power board 355, that is, as shown in FIG. 17.

In an embodiment, the electrical connection between the emitting board 322 and the receiving board 332 is realized by the flexible circuit board 36, and the emitting board 322, the receiving board 332, and the flexible circuit board 36 are integrally formed; the electrical connection between the receiving board 332 and the power board 355 is realized by another flexible circuit board 36, and the receiving board 332, the power board 355, and the flexible circuit board 36 are integrally formed, which can realize high integration of the whole machine and simple overall material control, and is beneficial to production, assembly, and cost reduction.

In an embodiment, when the LiDAR 3 is assembled, the light transmitting plate 34, the first housing 313, the emitting component 32, the receiving component 33, the power board 355, and the like can be first assembled to form a first assembly, the second housing 314, the waterproof and breathable valve, the connector, the adapter board 39, and the like can be assembled to form a second assembly, and then the first assembly and the second assembly can be assembled. The assembly is very convenient and reduces the cost of material management; and the first assembly can include all opto-mechanics and power supplies, and can already be tested and detected to a certain extent, which is beneficial to production. In the LiDAR 3, the first housing 313 and the second housing 314 can be formed by die casting and machining, which greatly reduces the production cost and the material management cost.

The first rigid circuit board 41 and the second rigid circuit board 42 can be designed to correspond to any two spaced rigid circuit boards in the LiDAR 3 along the first direction x.

In the description of this application, the terms such as "first", "second" are merely intended for description, but cannot be understood as indicating or implying relative importance. The meanings of the above terms in this application can be understood according to different situations. Unless otherwise specified, "a plurality of" means at least two, for example, two, three, four, and the like. "and/or" describes an association relationship of an associated object, indicating that three relationships can exist. For example, A and/or B can indicate the following three situations: only A exists, both A and B exist, and only B exists. The character "/" generally indicates that the associated objects before and after have an "or" relationship.

## Claims

1. A LiDAR, comprising:
a housing, having a receiving cavity and an opening in communication with the receiving cavity;
a light transmitting plate, covering the opening and connected to the housing;
an emitting component, located in the receiving cavity and comprising an emitting lens and an emitting board, wherein the emitting board is located on a side of the emitting lens away from the light transmitting plate;
a receiving component, located in the receiving cavity and comprising a receiving lens and a receiving board, wherein the receiving board is located on a side of the receiving lens away from the light transmitting plate;
a functional board located in the receiving cavity, on a side of the emitting board close to the light transmitting plate and a side of the receiving board close to the light transmitting plate, wherein the functional board is in contact with the housing and is configured to avoid an optical transmission path between the emitting board and the emitting lens and to further avoid an optical transmission path between the receiving lens and the receiving board.

2. The LiDAR according to claim 1, wherein the functional board is provided with a first avoidance region corresponding to the emitting lens and a second avoidance region corresponding to the receiving lens.

3. The LiDAR according to claim 2, wherein:
the functional board is located between the emitting lens and the emitting board, the first avoidance region is configured to allow detection light emitted by the emitting board to pass through, so that the detection light reaches the emitting lens; or
the functional board is located between a first end face of the emitting lens facing the light transmitting plate and a second end face of the emitting lens facing the emitting board, and the first avoidance region is configured to allow the emitting lens to pass through.

4. The LiDAR according to claim 3, wherein the emitting component further comprises an emitting shielding cover sleeved on the emitting board, the emitting shielding cover having a first light passing path, wherein:
when the functional board is located between the emitting lens and the emitting board, the emitting shielding cover is connected between the emitting board and the functional board, and the first light passing path is in communication with the first avoidance region; or
when the functional board is located between the first end face and the second end face, the emitting shielding cover is connected between the emitting board and the emitting lens, and the first light passing path is in communication with an incident light hole of the emitting lens.

5. The LiDAR according to claim 2, wherein:
the functional board is located between the receiving lens and the receiving board, and the second avoidance region is configured to allow echo light received by the receiving lens to pass through, so that the echo light reaches the receiving board; or
the functional board is located between a third end face of the receiving lens facing the light transmitting board and a fourth end face of the receiving lens facing the receiving board, and the second avoidance region is configured to allow the receiving lens to pass through.

6. The LiDAR according to claim 5, wherein the receiving component further comprises a receiving shielding cover sleeved on the receiving board, the receiving shielding cover having a second light passing path, wherein:
when the functional board is located between the receiving lens and the receiving board, the receiving shielding cover is connected between the receiving board and the functional board, and the second light passing path is in communication with the second avoidance region; or
when the functional board is located between the third end face and the fourth end face, the receiving shielding cover is connected between the receiving board and the receiving lens, and the second light passing path is in communication with an outgoing light hole of the receiving lens.

7. The LiDAR according to claim 2, wherein the emitting lens is connected with the functional board; and/or the receiving lens is connected with the functional board.

8. The LiDAR according to claim 1, wherein the housing comprises:
a first housing, provided with the opening and in contact with the functional board; and
a second housing, connected to one side of the first housing away from the opening and in contact with the emitting board and the receiving board.

9. The LiDAR according to claim 8, wherein the first housing is provided with a first step, and the functional board is located on the first step and is connected with a step wall of the first step.

10. The LiDAR according to claim 8, wherein:
the emitting lens comprises an emitting lens barrel and at least one emitting lens piece provided in the emitting lens barrel, the emitting lens barrel is integrally formed with the first housing;
the receiving lens comprises a receiving lens barrel and at least one receiving lens piece provided in the receiving lens barrel, the receiving lens barrel is integrally formed with the first housing.

11. The LiDAR according to claim 1, wherein the functional board comprises at least one of a power board and a main control board.

12. The LiDAR according to claim 1, wherein:
the emitting board and the receiving board are arranged at intervals in a direction perpendicular to the light transmitting plate, a partial projection of the emitting board onto the light transmitting board overlaps with a partial projection of the receiving board onto the light transmitting plate; or
the emitting board and the receiving board share a same substrate.

13. A LiDAR, comprising a housing and a plurality of mounting components, each mounting component comprising:
a first rigid circuit board, connected to the housing;
a second rigid circuit board, connected to the housing, wherein the second rigid circuit board is spaced apart from the first rigid circuit board in a first direction, and a portion of a projection of the second rigid circuit board on a first plane overlaps a portion of a projection of the first rigid circuit board on the first plane, the first direction being perpendicular to a surface of the first rigid circuit board, and the first plane being parallel to the surface of the first rigid circuit board;
a flexible circuit board, electrically connected to the first rigid circuit board and the second rigid circuit board and comprising a first bent portion and a second bent portion, the first bent portion and the second bent portion being provided along an extending direction of the flexible circuit board and bent in opposite directions, the first bent portion defining a first interval, and the second bent portion defining a second interval;
a first positioning member, located in the first interval and in contact with the first bent portion to position the first bent portion; and
a second positioning member, located in the second interval and in contact with the second bent portion to position the second bent portion.

14. The LiDAR according to claim 13, wherein the flexible circuit board comprises a first structural part, and the first positioning member and the second positioning member are connected with two opposite sides of the first structural part, respectively.

15. The LiDAR according to claim 14, wherein the first structural part is located between the first bent portion and the second bent portion along the extending direction of the flexible circuit board.
